(19) **Europäisches Patentamt**
**European Patent Office**
**Office européen des brevets**

(11) **EP 1 129 365 B1**

(12) **FASCICULE DE BREVET EUROPEEN**

(45) Date de publication et mention
de la délivrance du brevet:
**09.01.2008  Bulletin 2008/02**

(21) Numéro de dépôt: **00962647.4**

(22) Date de dépôt: **14.09.2000**

(51) Int Cl.:
***G01R 31/3183*** *(2006.01)*

(86) Numéro de dépôt international:
**PCT/FR2000/002554**

(87) Numéro de publication internationale:
**WO 2001/020355 (22.03.2001 Gazette 2001/12)**

(54) **PROCEDE DE LOCALISATION D'ELEMENTS DEFECTUEUX DANS UN CIRCUIT INTEGRE**

VERFAHREN ZUR ORTUNG DEFEKTER ELEMENTE AUF EINER INTEGRIERTEN SCHALTUNG

METHOD FOR LOCATING FAULTY ELEMENTS IN AN INTEGRATED CIRCUIT

(84) Etats contractants désignés:
**DE FR GB IE IT**

(30) Priorité: **15.09.1999  FR 9911534**

(43) Date de publication de la demande:
**05.09.2001  Bulletin 2001/36**

(73) Titulaire: **CENTRE NATIONAL D'ETUDES SPATIALES**
**75001 Paris (FR)**

(72) Inventeurs:
 • **ROLLAND, Guy**
   **F-31750 Escalquens (FR)**
 • **DESPLATS, Romain**
   **F-31400 Toulouse (FR)**

(74) Mandataire: **Blot, Philippe Robert Emile et al**
**Cabinet Lavoix**
**2, place d'Estienne d'Orves**
**75441 Paris Cedex 09 (FR)**

(56) Documents cités:
**EP-A- 0 305 217        EP-A- 0 444 487**
**EP-A- 0 720 097        US-A- 5 602 856**

 • **DESPLATS ET AL.: "NEW METHODOLOGY FOR LOCALIZING FAULTS IN PROGRAMMABLE AND COMMERCIAL CIRCUITS" MICROELECTRONICS AND RELIABILITY, vol. 37, no. 10/11, 1 novembre 1997 (1997-11-01), pages 1619-1622,**

**Description**

La présente invention concerne un procédé de localisation d'un élément défectueux dans un circuit intégré dont l'agencement théorique est connu, du type comportant une succession d'étapes consistant en :

- la détermination d'un point de mesure du circuit intégré ; et
- le test du point de mesure déterminé par mise en oeuvre de :

  - l'application d'une séquence de tests aux entrées du circuit intégré ;
  - la mesure de signaux au point de mesure déterminé du circuit intégré, lors de l'application de la séquence de tests ; et
  - l'évaluation du point de mesure par la comparaison des signaux mesurés avec des signaux théoriques devant être obtenus au point de mesure déterminé pour évaluer si le point de mesure est défaillant ou satisfaisant ; et

dans lequel la position de l'élément défectueux du circuit intégré est déterminée à partir des évaluations effectuées aux différents points de mesure déterminés,

Il est commode, pour la fabrication des circuits intégrés, ou lors de la recherche de défaillances de systèmes industriels, de pouvoir déterminer l'origine de défauts ou de pannes.

En particulier, dans le cas de circuits intégrés défectueux, il convient de pouvoir déterminer celui ou ceux des composants constituant le circuit intégré qui présentent une anomalie de fonctionnement.

Le nombre des composants entrant dans la constitution d'un circuit intégré est généralement très élevé de sorte que la localisation du ou des quelques éléments défectueux est très délicate à effectuer parmi la multitude d'éléments d'où la panne peut résulter.

On connaît actuellement un procédé d'analyse de circuits intégrés connu sous le terme anglais de "back tracking". Pour la mise en oeuvre de ce procédé, on utilise une installation de tests, permettant à l'aide de sondes matérielles ou virtuelles d'effectuer des relevés des signaux circulant en différents points de mesure du circuit.

A partir de la connaissance de la structure théorique du circuit intégré analysé, on détermine, en fonction d'une séquence de tests appliqués sur les entrées du circuit, les signaux devant être mesurés aux différents points de mesure du circuit.

Pour localiser les éléments défectueux dans le circuit, on considère d'abord une sortie défectueuse du circuit puis on remonte depuis cette sortie vers les entrées en testant de proche en proche chacun des points de mesure successifs. Tant que les mesures effectuées aux différents points révèlent des signaux incorrects par rapport aux signaux théoriques devant être obtenus, on déduit que les éléments défectueux du circuit sont en amont du point de mesure. Dès qu'on obtient, en un point de mesure, des signaux corrects, on déduit que l'élément défectueux est situé entre le point de mesure où des signaux corrects sont obtenus et le point de mesure précédent où des signaux incorrects de mesure ont été obtenus.

Chaque mesure effectuée réellement sur le circuit intégré nécessite un temps considérable pouvant aller de quelques secondes si le point de mesure est en surface à 5 à 10 minutes si le point de mesure est situé sur une couche profonde du circuit intégré et qu'un accès matériel préalable doit être ménagé à l'aide, par exemple, d'un faisceau d'ions focalisé.

On conçoit que, avec la méthode utilisée actuellement, il convient parfois de parcourir à rebours l'essentiel du circuit intégré si l'élément défectueux est très proche d'une entrée du circuit. Du fait de la complexité des circuits et des nombreuses ramifications le constituant, la recherche de l'élément défectueux peut s'avérer extrêmement longue.

L'invention a pour but de proposer un procédé de détection d'erreurs dans un circuit permettant une localisation plus rapide des zones défectueuses, tout en conservant une grande fiabilité dans cette localisation.

Des méthodes de recherche de solution à un problème sont décrites dans les documents EP-A-0.444.487 et R. Desplats et al., "New methodology for lacalizing faults in programmable and commercial circuits", Microelectronics and Reliability, vol. 37, n° 10/11, Oct.-Nov. 1997, pp. 1619-1622.

A cet effet, invention a pour objet un procédé du type précité, caractérisé en ce qu'il comporte initialement:

- une étape de modélisation de l'agencement théorique du circuit intégré, sous forme d'au moins un graphe comportant un ensemble de noeuds et d'arcs orientés des entrées du circuit vers les sorties du circuit;
- considérer comme un sous-graphe de recherche, un sous-graphe dont le noeud formant sommet correspond à un point de mesure défaillant ;

et en ce que, pour la recherche de l'élément défectueux, il comporte les étapes de :

- affecter à chaque noeud du sous-graphe de recherche considéré, une variable caractéristique dépendant de la structure du sous-graphe de recherche ;

- considérer comme point de mesure, le point de mesure correspondant à un noeud du sous-graphe considéré, obtenu par application d'un critère prédéterminé portant sur les variables caractéristiques de l'ensemble des noeuds du sous-graphe de recherche considéré ;
- effectuer un test du point de mesure considéré ;
- considérer comme nouveau sous-graphe de recherche :

    soit, le sous-graphe de recherche préalablement considéré en excluant le noeud correspondant au point de mesure testé et tous ses noeuds parents, si le point de mesure est satisfaisant
    soit, un sous-graphe dont le noeud correspondant au point de mesure est le sommet, si le point de mesure est défaillant ; et

- rechercher, dans le nouveau sous-graphe de recherche considéré l'élément défectueux, jusqu'à vérification d'un critère d'arrêt prédéterminé.

Suivant des modes particuliers de mise en oeuvre, le procédé comporte l'une ou plusieurs des caractéristiques suivantes :

- lors de l'étape initiale de modélisation de l'agencement théorique du circuit intégré, le circuit est modélisé sous forme d'un arbre par création éventuelle de noeuds virtuels lorsqu'un même noeud est le parent de au moins deux noeuds, eux-mêmes parents d'un même noeud ;
- il comporte, après vérification du critère d'arrêt prédéterminé, les étapes de :

    évaluer dans le ou chaque dernier sous-graphe de recherche, si pour chaque noeud virtuel correspondant à un point de mesure défaillant, le noeud jumeau associé audit noeud virtuel est un noeud du même sous graphe correspondant également à un point de mesure défaillant ; et
    considérer alors le ou chaque sous-groupe pour lequel la condition est vérifiée comme correspondant à une partie du circuit intégré comportant au moins un élément défectueux ;

- ladite variable caractéristique propre à chaque noeud est le nombre d'ancêtres de ce noeud dans le sous-graphe de recherche considéré ;
- ledit critère prédéterminé est adapté pour déterminer le noeud dont le nombre d'ancêtres est sensiblement égal au nombre moyen d'ancêtres par noeud dans le sous-arbre de recherche considéré ;
- il comporte une étape d'affectation à chaque noeud, d'un indicateur de conformité initialement fixé à un état défaillant ; et

pour la détermination du nouveau sous-graphe de recherche à considérer, il comporte les étapes de :

    fixer l'indicateur de conformité du noeud correspondant au point de mesure testé et de tous ses noeuds parents à un état satisfaisant, si le point de mesure testé est satisfaisant ; et
    considérer comme nouveau sous-graphe de recherche, le sous-graphe inclus dans le sous-graphe de recherche précédent et comportant les seuls noeuds dont l'indicateur de conformité est fixé à l'état défaillant ; et

    - le sous-graphe de recherche initialement considéré est formé de l'intersection des sous-graphes ayant chacun pour sommet un noeud correspondant à une sortie défaillante du circuit intégré.

L'invention a également pour objet un dispositif de localisation d'un élément défectueux dans un circuit intégré dont l'agencement théorique est connu, du type comportant des moyens pour effectuer une succession d'étapes consistant en :

- la détermination d'un point de mesure du circuit intégré ; et
- le test du point dé mesure déterminé par mise en oeuvre de :

    - l'application d'une séquence de tests aux entrées du circuit intégré;
    - la mesure de signaux au point de mesure déterminé du circuit intégré, lors de l'application de la séquence de tests ; et
    - l'évaluation du point de mesure par la comparaison des signaux mesurés avec des signaux théoriques devant être obtenus au point de mesure déterminé pour évaluer si le point de mesure est défaillant ou satisfaisant ; et

des moyens pour déterminer la position de l'élément défectueux du circuit intégré à partir des évaluations effectuées aux différents points de mesure déterminés,
caractérisé en ce qu'il comporte :

- des moyens de modélisation initiale de l'agencement théorique du circuit intégré, sous forme d'au moins un graphe comportant un ensemble de noeuds et d'arcs orientés des entrées du circuit vers les sorties du circuit ;
- des moyens pour considérer initialement comme un sous-graphe de recherche , un sous-graphe dont le noeud formant sommet correspond à un point de mesure défaillant ;

et en ce que, pour la recherche de l'élément défectueux, il comporte des moyens pour :

- affecter à chaque noeud du sous-graphe de recherche considéré, une variable caractéristique dépendant de la structure du sous-graphe de recherche ;
- considérer comme point de mesure, le point de mesure correspondant à un noeud du sous-graphe considéré, obtenu par application d'un critère prédéterminé portant sur les variables caractéristiques de l'ensemble des noeuds du sous-graphe de recherche considéré ;
- effectuer un test du point de mesure considéré ;
- considérer comme nouveau sous-graphe de recherche :

    soit, le sous-graphe de recherche préalablement considéré en excluant le noeud correspondant au point de mesure testé et tous ses noeuds parents, si le point de mesure est satisfaisant
    soit, un sous-graphe dont le noeud correspondant au point de mesure est le sommet , si le point de mesure est défaillant ; et

- rechercher, dans le nouveau sous-graphe de recherche considéré l'élément défectueux, jusqu'à vérification d'un critère d'arrêt prédéterminé.

L'invention sera mieux comprise à la lecture de la description qui va suivre, donnée uniquement à titre d'exemple et faite en se référant aux dessins sur lesquels :

- la figure 1 est une vue schématique d'un synoptique général donnant l'interdépendance des données et des actions lors de la mise en oeuvre d'un procédé selon invention ;
- la figure 2 est une vue plus détaillée de l'organigramme mis en oeuvre dans l'installation dont le synoptique est donné sur la figure 1 ;
- les figures 3 et 4 sont des vues schématiques respectivement d'un circuit élémentaire et de sa représentation sous forme d'un graphe d'influence inter-noeuds ;
- la figure 5 une vue d'un exemple d'une zone défaillante d'une modélisation d'un circuit intégré ;
- les figures 6 et 7 sont des vues respectivement d'une cellule défaillante seule et de deux cellules défaillantes partageant la même sortie ;
- les figures 8A et 8B sont des vues schématiques respectivement d'un graphe comportant un cycle et d'un arbre résultant d'une modification du graphe par application du principe de coupure ;
- la figure 9 une vue schématique de cellules de l'arbre illustrant le principe du parcours d'un arbre pour son marquage ;
- la figure 10 est un organigramme explicitant le séquencement général du marquage par la fonction **marquage () ;**
- la figure 11 est un organigramme explicitant la fonction **naeud_cherche_sorties()** utilisée lors du marquage ;
- la figure 12 est un organigramme explicitant la fonction **sortie_cherche_noeuds( )** utilisée lors du marquage ;
- la figure 13 est une vue schématique de la construction d'un sous-ensemble minimal;
- la figure 14 est une vue schématique d'intersections non connexes entre sous-graphes de l'arbre de référence ;
- la figure 15 est une vue schématique donnant un exemple d'une intersection de deux arbres ;
- la figure 16 est une vue schématique d'un arbre donnant un exemple de numérotation ;
- la figure 17 est un organigramme explicitant l'algorithme de recherche d'éléments défectueux par la fonction **dichotomie( )** ;
- la figure 18 est un organigramme explicitant le calcul et la localisation d'un noeud moyen par la fonction **chercher_noeud_moyen ( ) ;**
- la figure 19 est un organigramme explicitant le calcul du nombre de noeuds et du cumul des ancêtres par la fonction **calcul_moyenne()** ;
- les figures 20 et 21 sont des organigrammes explicitant les éléments modifiés de l'algorithme de la figure 19 pour la localisation d'un noeud moyen par la fonction localiser_moyenne () ;
- la figure 22 est une vue d'un arbre illustrant des exemples de résolutions autorisées et interdites ;

- la figure 23 est un organigramme explicitant la détermination des noeuds pouvant être déclarés sommet d'une zone défaillante par la fonction **analyser_cellules_restantes( ).**
- la figure 24 est un organigramme explicitant la construction de la liste des candidats par la fonction **construire_ liste_candidats( )**
- la figure 25 est un organigramme explicitant l'analyse sous un noeud sommet par la fonction **analyser_sous_ce_ sommet( ).**
- la figure 26 est un organigramme explicitant la construction de la liste des coupures par la fonction **lister_coupures_ a_resoudre( ).**
- la figure 27 est un organigramme explicitant l'algorithme de résolution des coupures par la **fonction-resoudre coupures( )** ; et
- la figure 28 est un organigramme explicitant la recherche d'une résolution interne par la fonction **chercher_un_ noeud()**.

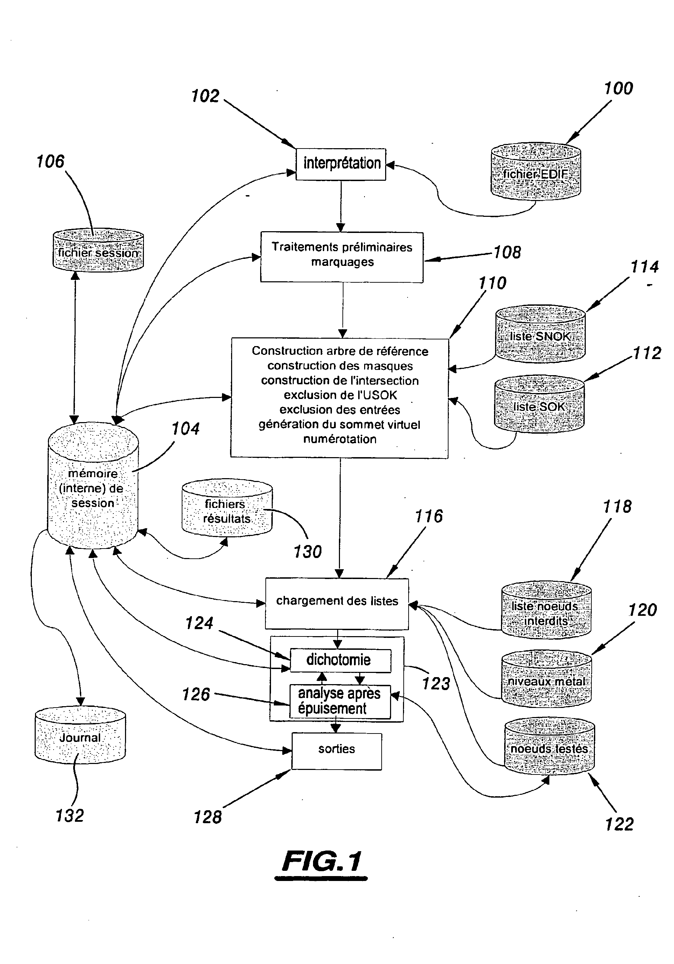

Sur la figure 1 est représenté le schéma synoptique des données et des actions mises en oeuvre par une installation de contrôle d'un circuit intégré mettant en oeuvre le procédé selon l'invention.

Le programme mis en oeuvre par cette installation permet de déterminer progressivement, à partir du schéma théorique d'un circuit intégré, les points où des mesures physiques doivent être réalisées par mise en oeuvre d'une séquence de tests appropriés.

Après chaque acquisition du résultat du test précédemment effectué, permettant de déterminer si le signal reçu au point de mesure est ou non correct, le procédé mis en oeuvre détermine un nouveau point où un test doit être effectué à partir d'une nouvelle séquence de tests.

Au fur et à mesure de l'acquisition des résultats, des tests proposés automatiquement, le procédé selon l'invention permet de localiser la région du circuit intégré dans laquelle se trouve l'élément défectueux puis finalement de localiser celui-ci de manière rapide.

Les séquences de tests mises en oeuvre pour chacun des points de mesure du circuit intégré sont de tout type adapté et sont par exemple comparables à celles mises en oeuvre dans un procédé de "back tracking". Les séquences de tests étant connues en soi, elles ne seront pas décrites dans la suite de la description.

De même, les moyens utilisés pour assurer la mesure d'un signal en un point de mesure déterminé du circuit intégré, lors de l'application d'une séquence de tests ne seront pas décrits en détail, ceux-ci étant de tout type adapté.

Le procédé selon l'invention peut être mis en oeuvre avec une installation comportant, d'une part, des moyens de test tels qu'un microscope électronique à balayage permettant d'effectuer des relevés des signaux circulant en des points de mesure déterminés du circuit intégré lors de l'application d'une séquence de tests, et, d'autre part, une unité de traitement d'informations, telle qu'un micro-ordinateur mettant en oeuvre un programme adapté déterminant, suivant le procédé de l'invention, les points du circuit où des mesures successives doivent être effectuées, et déduisant des résultats de mesures la position des éléments défectueux dans le circuit.

Sur la figure 1 sont illustrés les différents fichiers de données utilisés ainsi que les traitements opérés sur ceux-ci, afin de déterminer, d'une part, les points successifs où des mesures doivent être effectuées sur le circuit et, d'autre part, les éléments ou zones défectueux du circuit.

La structure générale du programme met en oeuvre la notion de session.

Une session peut être définie comme un ensemble de fichiers cohérents relatifs à des conditions données pour les entrées et les paramètres du programme. Une session contient aussi l'ensemble des fichiers intermédiaires générés par le programme, nécessaires au fonctionnement, et à la mémorisation du numéro de la dernière étape de calcul effectuée.

Le contenu d'une session est défini dans un fichier texte dont le nom porte l'extension « .ses ». La racine du nom est définie librement par l'utilisateur.

Le chargement par le programme d'un fichier de session préexistant restaure le contexte de calcul propre à cette session (mêmes fichiers de données, mêmes paramètres de contrôle et résultats intermédiaires) et permet le redémarrage des calculs à l'endroit où ils avaient été interrompus.

Le séquencement des différentes opérations est effectué par une fonction **main( )**.

Le code de cette fonction se trouve dans un fichier « principal.c ».

Selon le principe du programme, les différentes opérations sont enchaînées de manière séquentielle.

On distingue cinq phases principales qui seront détaillées dans la suite :

- La phase d'interprétation de l'EDIF
- La phase de marquage
- La phase de numérotation (cette phase englobe la construction de l'arbre de référence, celle du sous-ensemble minimal et la création du sommet virtuel)
- La phase de localisation des fautes

• La phase de compte-rendu.

A l'issue dé chacune de ces phases, les calculs peuvent être interrompus. Dans ce cas, tous les résultats intermédiaires nécessaires à la reprise ultérieure des calculs sont automatiquement archivés dans des fichiers de sauvegarde. Ces fichiers ont des noms comportant une extension « data ». Le degré d'avancement des calculs est également archivé.

La reprise des calculs se fait de façon transparente, c'est-à-dire sans avoir à faire référence à ces fichiers intermédiaires, en chargeant simplement le fichier de session approprié.

Initialement, la structure théorique du circuit, c'est-à-dire la structure d'un circuit sans défaut, est stockée dans un fichier 100, qui est par exemple au format EDIF.

Ce fichier est traité d'abord lors d'une phase d'interprétation 102 permettant la mise en forme du fichier décrivant le circuit théorique sous forme d'un format interne propre à la mise en oeuvre du procédé. La réalisation de l'interprétation 102 et le format propre à l'application du procédé seront décrits dans ia suite de la description.

Généralement, l'interprétation consiste à modéliser le circuit théorique sous la forme d'un graphe, dont les noeuds correspondent aux entrées et aux sorties des différents composants du circuit intégré et dans lequel les composants sont représentés par des ensembles d'arcs orientés reliant les noeuds entre eux.

L'algorithme d'interprétation reçoit et adresse des données à une mémoire interne de session 104 assurant notamment un stockage temporaire du fichier contenant le graphe du circuit présenté suivant un format exploitable.

Cette mémoire 104 est reliée à un fichier de session 106 assurant un stockage des données de session sur un support permanent tel qu'un disque dur.

A l'issue de l'interprétation 102, le fichier dé session est soumis à une phase de marquage 108 associée à d'autres traitements préliminaires.

La phase suivante notée 110 est dite "phase de construction d'un sous-ensemble minimal et de numérotation". Elle a notamment pour but la définition de sous-ensembles parmi les différents arbres modélisant le circuit. En particulier, lors de la phase 110, sont prises en compte deux séries d'informations à savoir la liste des sorties du circuit fonctionnant correctement, notée 112, et la liste des sorties du circuit ne fonctionnant pas correctement notée 114. A cet effet, les sorties du circuit sont testées à partir de séquences de tests, comme cela sera expliqué dans la suite de la description.

A partir du fichier de session obtenu en sortie de l'étape 110, une phase 116 de chargement des listes est mise en oeuvre. Cette phase prend en compte la liste des noeuds interdits stockés dans un fichier 118, la liste des niveaux de métal 120 précisant les couches métalliques sur lesquelles sont présents les différents éléments du circuit, ainsi qu'un fichier 122 comportant la liste des noeuds déjà testés.

La phase ultérieure 123 consiste en la localisation des composants ou groupes de composants défectueux, causant des fautes dans le fonctionnement du circuit. Selon l'invention, cette recherche des fautes s'effectue suivant un procédé de dichotomie pratiqué sur certains arbres particuliers du circuit, en tenant compte d'une pondération encore appelée numérotation de chacun des noeuds effectuée suivant une méthode prédéterminée.

Lors de la phase de dichotomie notée 124, est également mise en oeuvre une phase d'analyse supplémentaire 126 dite "phase d'analyse après épuisement" permettant de compléter la recherche des fautes effectuée par dichotomie. Cette phase supplémentaire permet de tenir compte des contraintes de modélisation du circuit qui ont conduit à certaines modifications conventionnelles du graphe le représentant.

Enfin, les résultats sont mis à disposition de l'utilisateur lors de la phase ultime 128.

Comme représentée sur le schéma synoptique, chacune des phases de traitement 102, 108, 110, 116, 124, 126, 128 reçoit et adresse des données depuis et vers la mémoire interne de session 104. Cette dernière est de plus reliée à un ensemble de fichiers résultats 130, ainsi qu'à un journal de stockage 132. Ces derniers assurent respectivement la mise à disposition de l'utilisateur des résultats de l'analyse et l'archivage des commentaires imprimés à l'écran.

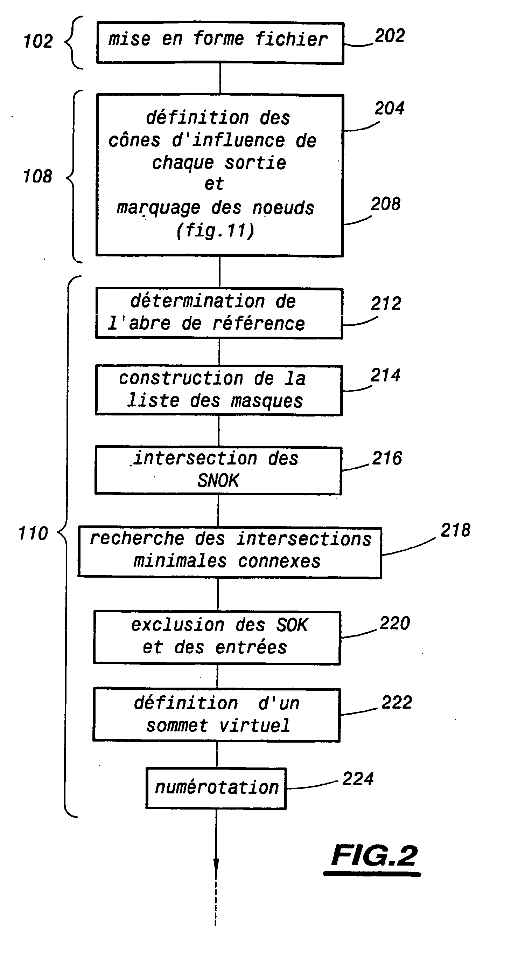

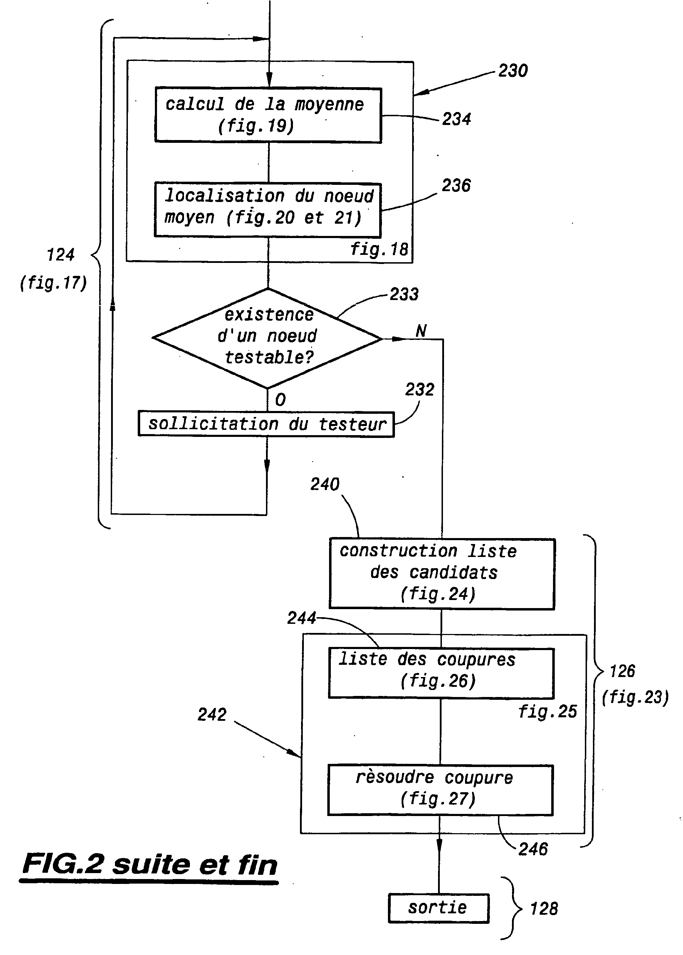

Sur la figure 2 est décrite plus en détail chacune des phases successives 102, 108, 110, 124 et 126 de mise en oeuvre du procédé selon l'invention.

Ainsi, la description détaillée de l'algorithme total va être effectuée en regard de la figure 2, où chacune des étapes élémentaires sera décrite successivement en référence à d'autres figures illustratives encore plus détaillées.

La première étape de la phase initiale 102 de mise en forme du fichier décrivant le circuit intégré est désignée par la référence 202 sur la figure 2.

De manière générale, un circuit peut toujours être décrit comme un ensemble de cellules comportant des entrées et des sorties connectées par des noeuds. Le choix du niveau hiérarchique de définition d'une cellule est arbitraire. Il s'agit par exemple d'un sous-ensemble fonctionnel constituant une macro-cellule, d'une porte ou d'un transistor. De même, la notion d'entrées et de sorties du circuit à analyser peut être immédiatement transposée aux entrées et sorties d'un bloc interne, l'analyse portant alors sur ce bloc.

Avec le type de description utilisé, les signaux ne sont observés que sur les noeuds.

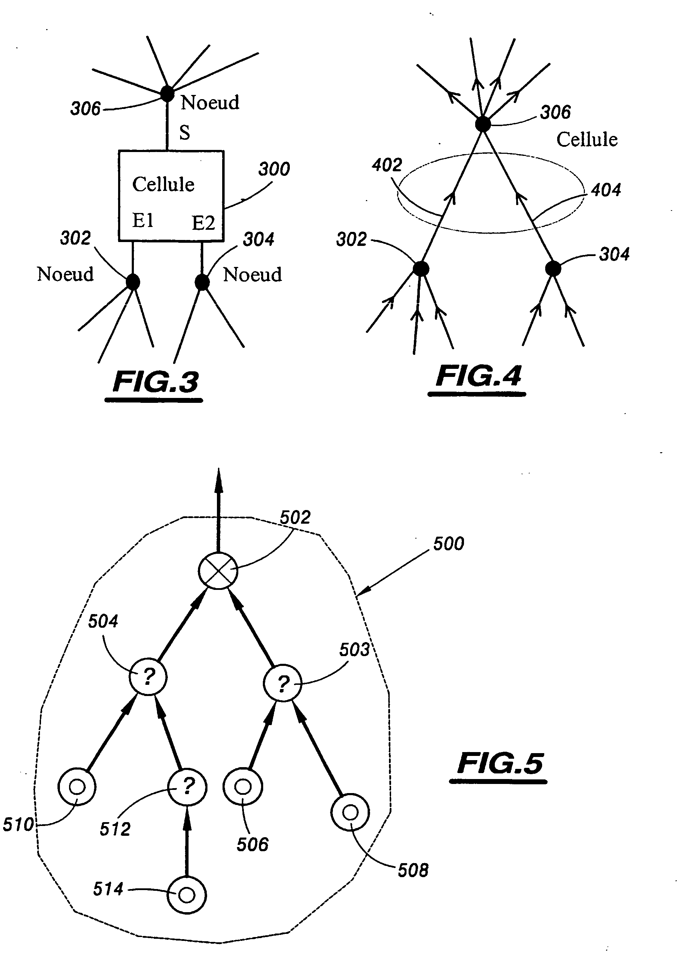

La description des cellules se réduit à l'influence qu'exercent leurs noeuds d'entrée sur leurs noeuds de sortie. La description initiale du circuit formée d'un ensemble de cellules et de noeuds, peut donc être transformée en un graphe d'influence inter-noeuds en remplaçant chaque cellule, dont un exemple est donné sur la figure 3, par un ensemble d'arcs orientés tel qu'illustré sur la figure 4.

Sur la figure 3, est représentée une cellule 300 constituée par exemple d'une porte ET. Cette cellule comporte deux entrées E1 et E2 reliées à des noeuds d'entrée 302 et 304 respectivement. Ces noeuds d'entrée sont reliés aux sorties d'autres cellules non représentées du circuit intégré. La sortie, notée S, de la cellule 300 est reliée à un noeud 306 auxquelles sont reliées les entrées d'autres cellules non représentées du circuit intégré.

Sur la figure 4, la cellule 300 est remplacée par deux arcs orientés 402 et 404 reliant respectivement les noeuds d'entrée 302 et 304 aux noeuds de sortie 306 de la cellule.

Ainsi, la cellule 300 est modélisée simplement par les deux arcs orientés 402 et 404.

Grâce à une telle modélisation de toutes les cellules, la description totale du circuit prend ainsi la forme d'un graphe.

Dans une telle modélisation du circuit et comme illustré sur la figure 5, une zone défaillante 500 est un sous-graphe et même, après application de modifications qui seront explicitées ultérieurement, un sous-arbre.

Sur cette figure apparaissent plusieurs types de noeuds.

Les noeuds mauvais sont désignés par un rond au centre duquel figure une croix. Les noeuds mauvais sont les noeuds pour lesquels, pour une séquence de tests donnée appliquée à l'entrée du circuit, est obtenu un signal différent du signal théorique devant être obtenu pour ce point de mesure.

Certains noeuds sont des noeuds non testables. Il s'agit par exemple des noeuds situés sur des couches profondes du circuit intégré auxquels l'accès est impossible ou difficile. Ces noeuds sont désignés par un rond à l'intérieur duquel figure un point d'interrogation.

Les noeuds bons, par opposition aux noeuds mauvais, sont des noeuds où pour une séquence de tests donnée, le signal mesuré correspond au signal théorique devant être obtenu. Ces noeuds bons sont désignés par un rond à l'intérieur duquel figure un autre rond.

Dans l'exemple de la figure 5, la zone défaillante 500 est constituée d'un sous-arbre dont le sommet 502 est un noeud mauvais. Ce noeud mauvais 502 est commandé par deux noeuds non testables 503 et 504. Le premier noeud non testable 503 est relié à deux noeuds bons 506 et 508. Le second noeud non testable 504 est relié à un noeud bon 510 et à un noeud non testable 512 lui-même relié à un noeud bon 514.

De manière générale, un sous-arbre constituant une zone défaillante a les propriétés suivantes :

- Le sommet est un noeud sur lequel le signal est mauvais.
- Toutes les terminaisons sont des noeuds sur lesquels le signal est bon.
- Il peut exister des noeuds non testables entre le sommet et les terminaisons. Dans le cas contraire, il s'agit d'une cellule défaillante ou de cellules défaillantes dont les sorties sont connectées au même noeud.

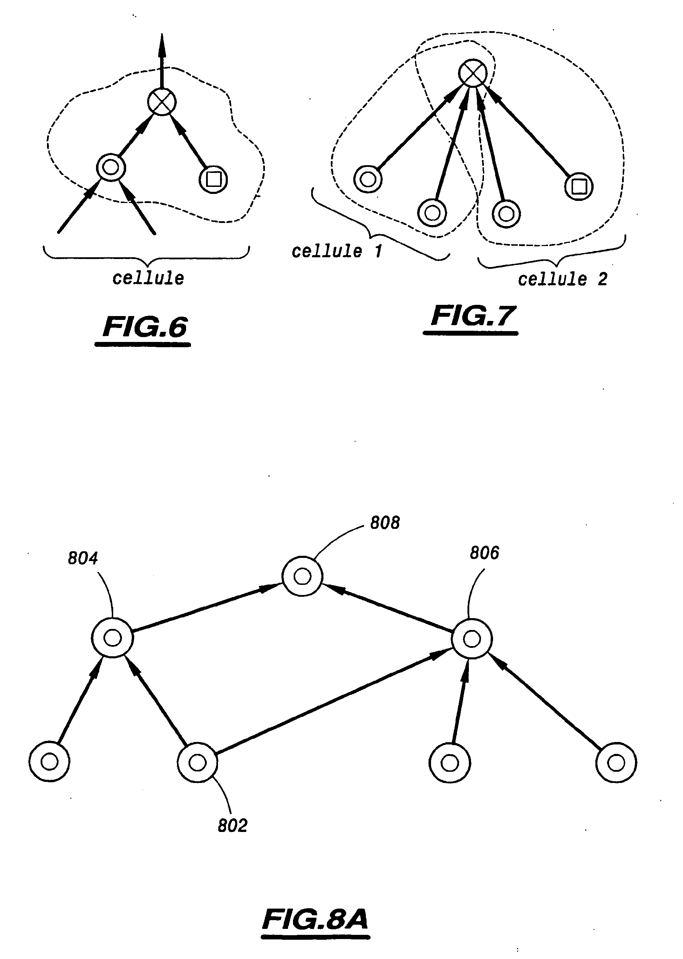

Un exemple de cellule défaillante seule est représenté sur la figure 6. Un exemple de deux cellules défaillantes partageant la même sortie est décrit sur la figure 7. Sur ces figures, les conventions de la figure 5 sont utilisées.

Dans la pratique, l'étape d'interprétation 202 consiste à transformer le fichier initial de description du circuit, au format Edif, par exemple, en un fichier d'un format déterminé propre à la mise en oeuvre du procédé (fichier dont le nom porte le suffixe « .parsed »).

Suivant la nature du fichier initial (repérée par l'un des suffixes « .edn », « .edf » ou « .edo »), le programme lance l'interpréteur approprié.

Ces programmes d'interprétation sont utilisés comme des commandes du système d'exploitation par la fonction « **system( )** » du langage C.

Dans les cas où la description initiale n'est pas conforme aux formats des interpréteurs disponibles, il est toujours possible d'utiliser directement une description au format interne (format « .parsed »).

Le format de ces fichiers internes est donné sur la table 1.

Les contraintes conventionnelles à respecter sont les suivantes:

- Il s'agit d'un fichier texte.
- On ne doit pas sauter de ligne.
- Les différents blocs doivent être placés dans l'ordre suivant: les blocs décrivant les sorties ; les blocs décrivant les entrées ; les blocs décrivant les cellules internes et les blocs décrivant les noeuds.
- La numérotation des sorties commence à zéro et se termine à N.
- La numérotation des entrées commence à N+1 et se termine à (Nombre_de_broches - 1).
- La numérotation des cellules internes (instances) commence à (Nombre_de_broches) et se termine à (Nombre_de_broches + Nombre_de_cellules_internes - 1).
- Les noeuds sont numérotés de zéro à (Nombre_de_noeuds - 1).
- La numérotation des noeuds dans les blocs relatifs aux sorties, aux entrées et aux cellules instanciées doit être cohérente avec la numérotation des blocs décrivant les noeuds.

- Les numéros des cellules dans les blocs décrivant les noeuds doivent être cohérents avec la numérotation des cellules instanciées, la numérotation des entrées, ainsi que la numérotation des sorties effectuée en amont dans le fichier.

```
Nombre_de_broches        Nombre_de_cellules_internes        Nombre_de_nœuds

Nom_Cellule_Sortie      Numéro_Cellule_Sortie      ⎫
1                                                  ⎬  A répéter pour chaque broche de sortie
Nom_Broche_entrée                                  ⎪
Numéro_du_nœud_d'entrée                             ⎭
0

Nom_Cellule_Entrée      Numéro_Cellule_Entrée      ⎫
0                                                  ⎬  A répéter pour chaque broche d'entrée
1                                                  ⎪
Nom_Broche_sortie                                  ⎭
Numéro_du_nœud_de_sortie

Nom_Cellule        Numéro_Cellule                        ⎫
Nombre_entrées                                           ⎪
                                                         ⎪
Nom_Broche_entrée        ⎫                                ⎪
Numéro_du_nœud_d'entrée  ⎬ Pour chaque entrée de cellule ⎬ Pour chaque cellule interne
                         ⎭                                ⎪
Nombre_sorties                                           ⎪
                                                         ⎪
Nom_Broche_sortie        ⎫                                ⎪
Numéro_du_nœud_de_sortie ⎬ Pour chaque sortie de cellule ⎭

Nom_du nœud        Numéro_du_nœud                         ⎫
Nombre_de_broches_connectées_à_ce_nœud                   ⎪
                                                         ⎬ Pour chaque noeud
Nom_broche                            ⎫ Pour chaque broche ⎪
Numéro_cellule_à_laquelle_la_broche_appartient ⎬ (cellule ou entrée/sortie) ⎭
```

**Table 1** : Structure d'un fichier au format de description interne (« .parsed »)

Trois listes fondamentales sont construites à partir de ce fichier. Il s'agit de :

- Une liste chaînée de structures de type NOEUD pour décrire les noeuds;
- Une liste chaînée de structures de type CELLULE pour décrire le brochage ;
- Une liste chaînée de structures de type CELLULE pour décrire les cellules instanciées ;

La définition de ces structures se trouve dans un fichier d'en-tête « structures.h ».

Toutes les autres structures de données construites par la suite contiennent, en général, des pointeurs vers les éléments de ces listes de manière à éviter au maximum la duplication des informations.

La première étape 204 de la phase de marquage et de traitements préliminaires 108 consiste à trouver, pour chaque sortie du circuit intégré, l'ensemble des noeuds susceptibles de l'influencer. Ces ensembles de noeuds sont appelés « cônes d'influence ». Simultanément est effectué un marquage des noeuds comme cela sera décrit dans la suite de la description.

A l'issue de cette étape 204, il est possible d'énumérer, pour chaque noeud du circuit, l'ensemble des sorties du circuit que le noeud est susceptible d'influencer. C'est à partir des cônes d'influence, affectés à chaque noeud, que s'effectuent les différentes opérations d'intersection et d'exclusion présentées dans la suite de la description.

Au début de l'étape 204 de construction des cônes d'influence, on effectue un certain nombre de calculs préliminaires relatifs aux sorties. Cela consiste à :

- Compter le nombre de sorties ;
- Compter le nombre de groupes de marqueurs ;
- Remplir les tableaux communs associés aux sorties.

Ces tableaux communs sont:

- Le tableau donnant le numéro de groupe de chaque sortie : **groupeSortie[];**
- Le tableau donnant le rang de chaque sortie : **rangSortie[]** ;
- Le tableau donnant la valeur numérique du marqueur pour chaque sortie : **marqueurSortie[]** ;
- Le tableau contenant les adresses des structures relatives à chaque sortie : **adresseSortie[]** ;
- Le tableau des noms des sorties **nomSortie[]** ;
- Le tableau contenant le nombre total de noeuds dans le cône relatif à chaque sortie : **totalSortie[ ]**.

L'utilité de ces différents tableaux apparaît après la lecture des paragraphes suivants relatifs à la méthode de marquage des noeuds.

Pour construire le cône d'influence d'une sortie, on part de cette sortie et on parcourt le graphe d'influence avec un algorithme standard de parcours des arbres tel qu'un algorithme à « ordre préfixé ».

Comme le graphe d'influence n'est pas un arbre, suivant la nature du circuit initial, ce graphe peut comporter des cycles dus à la présence dans le circuit de boucles séquentielles ou combinatoires.

Lorsqu'on s'engage dans un tel cycle, on revient à un moment donné sur un noeud déjà analysé. L'algorithme est adapté pour détecter le retour sur un noeud. Quand cet événement se produit, l'algorithme crée une terminaison fictive, dénommée "coupure", et rebrousse chemin.

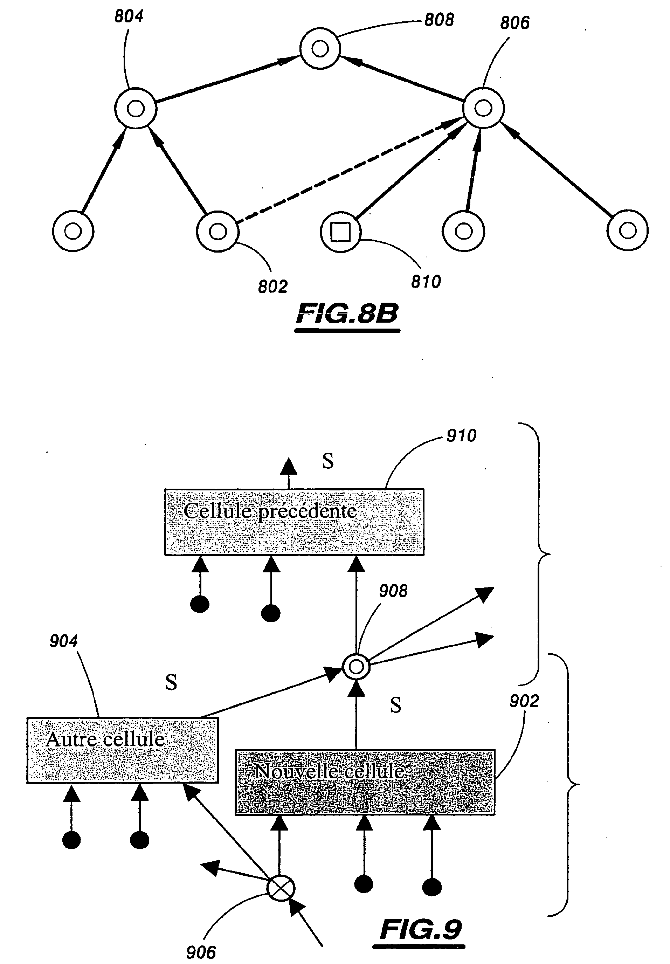

Suivant le principe des coupures, on effectue des coupures quand on revient sur des noeuds déjà analysés. La notion de coupure est illustrée sur les figures 8A et 8B.

Sur la figure 8A est représenté un graphe d'influence ne présentant pas la forme d'un arbre puisque l'un des noeuds noté 802 est le parent de deux noeuds 804 et 806, ces derniers étant eux-mêmes les parents d'un même noeud 808. Ainsi, les noeuds 802, 804, 808 et 806 forment une boucle combinatoire.

Afin de créer un arbre à partir du graphe de la figure 8A, et comme illustré sur la figure 8B, un noeud virtuel 810, constituant une coupure est ajouté comme parent du noeud 806. Dans la suite des dessins, les coupures sont représentées par un rond renfermant un carré.

Le noeud 802 est conservé comme parent du noeud 804. Ainsi, le noeud 810 constitue un noeud jumeau virtuel du noeud 802. L'arc orienté issu du noeud 802 et pointant sur le noeud 806 est supprimé dans la structure de données. Il est indiqué pour mémoire en traits pointillés sur la figure 8B.

Dans la structure de données, un champ « parent » de la structure décrivant le noeud 810 pointe sur le noeud jumeau 802 dans la liste des noeuds. En opérant de cette manière, on obtient un arbre puisque tous les cycles sont ouverts.

Les cônes d'influence sont donc des sous-graphes du graphe d'influence munis de coupures appropriées.

Ils ont une structure d'arbre dont le sommet est une sortie et les terminaisons sont soit des entrées soit des coupures.

Simultanément à la définition des cônes d'influence est effectué un marquage des noeuds.

Le but du marquage est d'enregistrer pour chaque noeud les sorties du composant qu'il influence.

Cet enregistrement se fait en agissant sur un "marqueur" associé à chaque noeud.

Chaque fois qu'on trouve le long du parcours un noeud nouveau, on attribue à la variable "marqueur", qui est affectée au noeud, le numéro de la sortie dont on construit le cône d'influence.

Ces marqueurs sont des tableaux de nombres entiers dont le type (TYPEMASQUE) est un type prédéfini dans l'en-tête « structure.h ». Le champ « marqueur » dans chaque structure « NOEUD » est un pointeur sur le premier élément de ce tableau.

Chacun des bits de ces entiers est utilisé pour mémoriser si une sortie est influençable ou non par ce noeud. Si le bit correspondant à la sortie d'indice n est mis à 1, le noeud influence la sortie n. Sinon ce bit est laissé à zéro.

Comme les entiers sont limités en nombre de bits, il faut partager l'ensemble des sorties en groupes et affecter un entier à chaque groupe pour la mémorisation des sorties du groupe. Le nombre de sorties codables est ainsi illimité.

Dans un premier temps, le programme compte les broches de sortie.

Soit « nombreDeSorties » le nombre des broches de sorties.

Le nombre de bits par entier est donné par une instruction du langage C:

$$NOMBREDEBITS = sizeof(TYPEMASQUE) * 8.$$

Le nombre de groupes est donc donné par:

$$nombreDeGroupes = PartieEntière((nombreDeSorties - 1) / NOMBREDEBITS) + 1$$

Ce nombre de groupes sert à dimensionner les tableaux de marquage.

Le groupe de la sortie n est déterminé par : groupeSortie[n] = PartieEntière(n / NOMBREDEBITS).

On définit également le rang de la sortie n par : rangSortie[n] = n Modulo(NOMBREDEBITS).

Une sortie donnée est donc repérée par un couple (groupe, rang).

Pour mettre à 1 le bit correspondant à la sortie numéro n, on ajoute « 2 à la puissance rangSortie[n]» à l'entier du tableau correspondant au groupe de la sortie n.

Pour chaque sortie, la valeur correspondante de cet incrément du marqueur est calculée dans les calculs préliminaires. Ces valeurs sont mémorisées dans le tableau commun « marqueurSortie[] ».

Si « node » est le pointeur contenant l'adresse du noeud à traiter, l'activation de son marqueur pour la sortie « n » se fait donc avec l'instruction C suivante :

$$node->marqueur[groupeSortie[n]] += marqueurSortie[n] ;$$

Pour que ce mécanisme fonctionne, il faut que chaque noeud pouvant être marqué pour la sortie n ne le soit qu'une seule fois. Avant de marquer un noeud pour la sortie n, il faut donc tester si ce noeud a déjà été marqué ou non pour cette sortie. Pour ce faire, on opère de la façon suivante :

L'adresse « node » du noeud et le numéro n de la sortie étant donnés, on détermine le groupe correspondant à cette sortie en lisant le tableau groupeSortie[].

On utilise ce numéro de groupe pour localiser l'élément correspondant à cette sortie dans le tableau marqueur associé à ce noeud.

On applique le ET logique entre cet élément du tableau et la valeur contenue dans le tableau commun marqueurSortie[] pour ce numéro de sortie, c'est-à-dire :

$$test = (node->marquéur[groupeSortie[n]]) \& (marqueurSortie[n]);$$

La valeur de test est différente de zéro si le bit correspondant à la sortie n est déjà à la valeur 1 dans le marqueur associé au noeud.

L'attribution des valeurs correctes aux marqueurs associés à chaque noeud est effectuée en exécutant l'algorithme de marquage dont le principe est exposé ci-dessous

Cet algorithme garantit que tout noeud est marqué une fois et une seule pour toutes les sorties qu'il est capable d'influencer.

Cet algorithme est adapté au cas des marqueurs vectoriels, exposé ci-dessus. Il est également adapté pour la construction de l'arbre de référence, comme cela sera exposé dans la suite.

Le principe de l'algorithme est de parcourir le cône d'influence du circuit depuis chaque sortie avec un algorithme standard de parcours des arbres tel qu'un algorithme à ordre « préfixé ». Chaque fois qu'un noeud peut être marqué, on vérifie s'il ne l'a pas déjà été. S'il a déjà été marqué, l'algorithme considère qu'il a atteint une terminaison et il rebrousse chemin.

Pendant le marquage, on compte également le nombre total de noeuds contenus dans chaque cône d'influence. Ces totaux sont stockés dans le tableau commun « totalSortie[ ] ».

La valeur « zéro » du paramètre « mode » indique à l'algorithme qu'il doit effectuer le marquage des noeuds. La valeur « un » du paramètre « mode » indique à l'algorithme qu'il doit effectuer la construction de l'arbre de référence.

La construction de l'arbre de référence sera explicitée dans la suite de la description.

Le parcours du graphe s'effectue par l'appel récursif de deux fonctions illustrées schématiquement sur la figure 9.

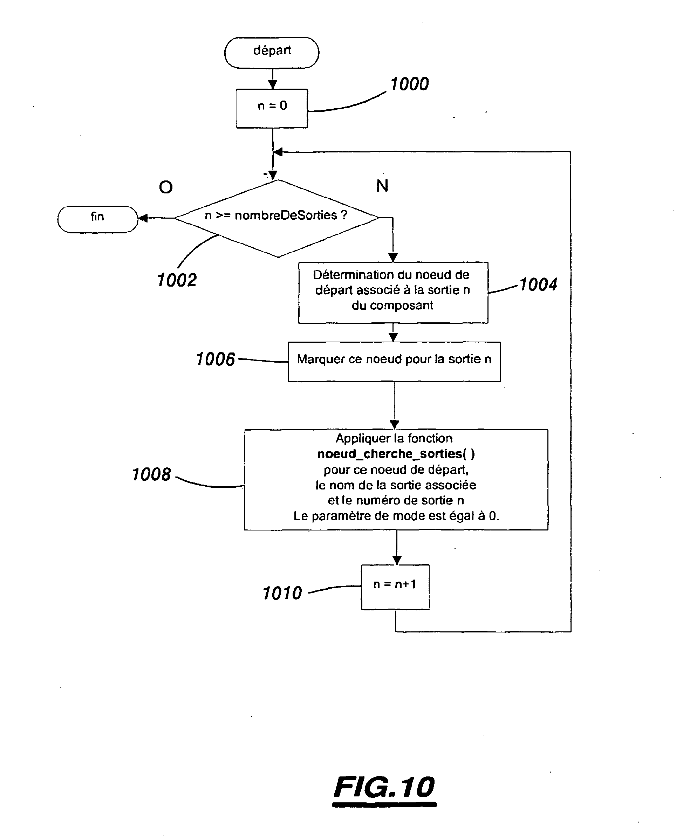

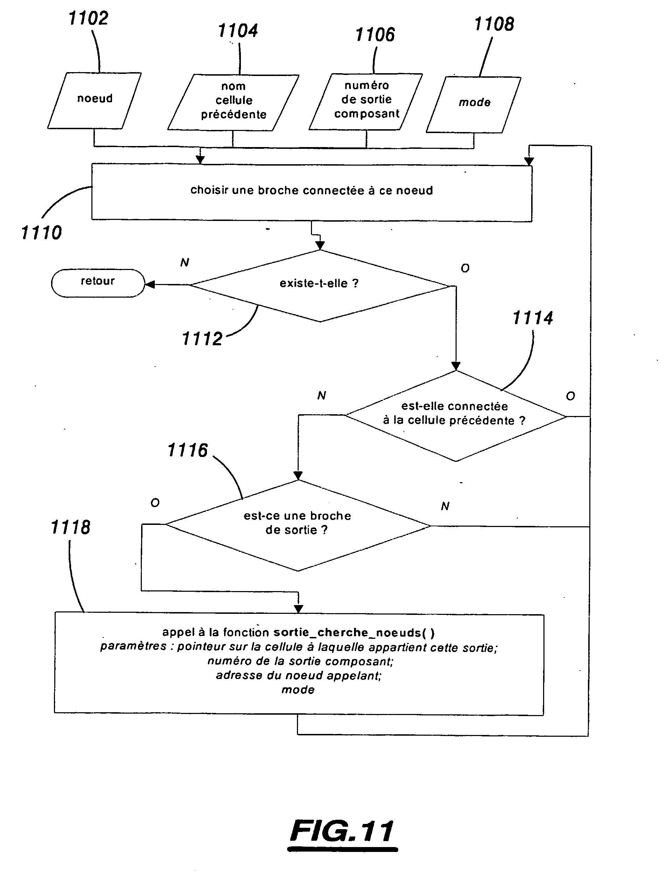

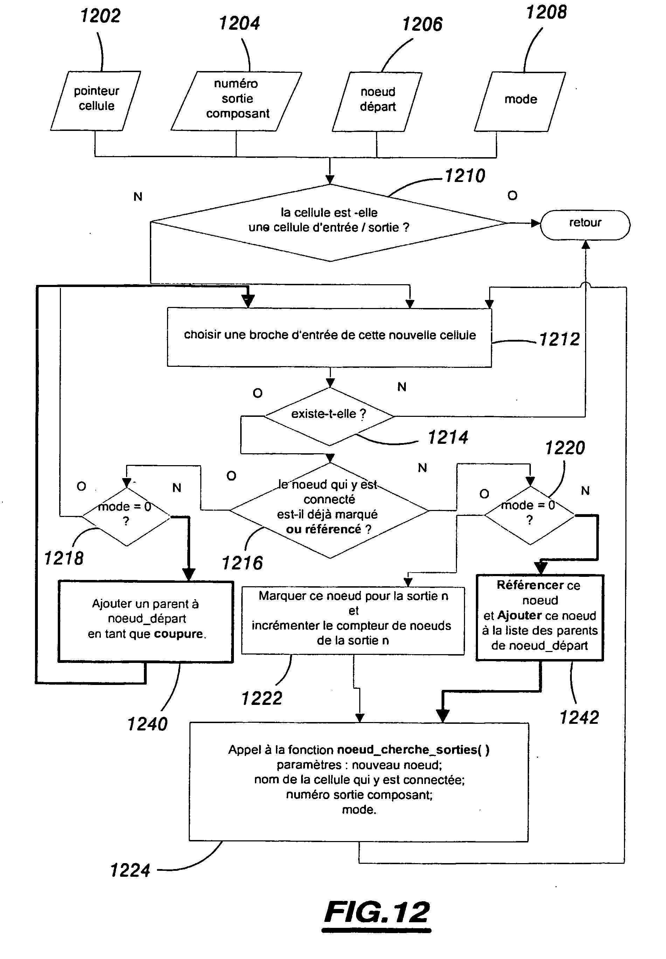

L'enchaînement des différentes étapes de l'algorithme de marquage objet de la fonction **marquage ( )** est exposée sur la figure 10. Ces différentes étapes font appel aux fonctions ci-dessous exposées qui seront décrites en regard des figures 11 et 12.

- **La fonction noeud_cherche_sorties()** (figure 11) : cette fonction est exécutée lors de l'analyse de l'environnement d'un noeud. Elle recherche les différentes sorties de cellules connectées à un noeud donné et pour chacune de ces sorties appelle la fonction **sortie_cherche_noeuds( ).**
- **La fonction sortie_cherche_noeuds( )** (figure 12) : cette fonction est exécutée lors de l'analyse des entrées de la cellule dont la sortie à été sélectionnée par la fonction **noeud_cherche_sorties( )**. Pour chacune des broches d'entrée de cette cellule, elle marque, s'il y a lieu, le noeud où elle est connectée et fait un appel à la fonction **noeud_cherçhe_sorties( )** depuis ce nouveau noeud.

Sur la figure 9, sont représentées deux cellules 902 et 904 dont la sortie est reliée à un même noeud 908 relié à une entrée d'une autre cellule 910. De même, deux entrées des cellules 902 et 904 sont reliées à un même noeud 906.

En initialisant le procédé sur le noeud 908, l'application de la fonction **noeud_cherche_sorties ()** permet d'identifier une des sorties des cellules 902 et 904. L'application ultérieure de la fonction **sortie_cherche_noeuds ()** permet de trouver le noeud 906 auquel sont connectées des entrées des cellules 902 et 904.

On conçoit que l'application récursive des deux fonctions permet de parcourir l'ensemble du graphe.

Sur la figure 10, est précisé l'organigramme de la fonction marquage. Sur cette figure, la variable n est utilisée pour parcourir les sorties du circuit intégré à tester. Initialement, à l'étape 1000, la variable n est fixée à 0.

Tant qu'il reste des sorties du circuit intégré à parcourir, la procédure de marquage est mise en oeuvre. A cet effet, un test est effectué à l'étape 1002 pour comparer la variable n au nombre total de sorties du circuit intégré.

A l'étape 1004, est déterminé le noeud de la modélisation du circuit intégré associé à la sortie n considérée.

A l'étape 1006, ce noeud est marqué pour la sortie n.

A l'étape 1008, la fonction **noeud_cherche_sorties ()** est appliquée pour le noeud considéré. Ainsi, par l'application successive des fonctions récusives **noeud_cherche_sorties ()** et **sortie_cherche_noeuds (),** l'ensemble de l'arbre associé à la sortie est parcouru par application des algorithmes décrits en regard des figures 11 et 12.

Après épuisement de l'arbre associé à la sortie n, la variable n est incrémentée à l'étape 1010. Le test opéré à l'étape 1002 est alors remis en oeuvre. La fonction marquage s'achève après que toutes les sorties du circuit intégré ont été traitées.

La fonction **noeud_cherche_sorties ()** dont l'organigramme est présenté sur la figure 11, reçoit en entrée le noeud 1102 depuis lequel elle opère, le nom de la cellule précédente 1104, le numéro de la sortie du circuit intégré 1106 dont l'arbre est en cours de marquage ainsi que le mode de fonctionnement de la fonction 1108. Pour le marquage, et comme indiqué précédemment, le mode est fixé à 0. '

A l'étape initiale 1110, une broche connectée au noeud fourni en 1102 est choisie. Il est vérifié à l'étape 1112 que cette broche existe. Si tel est le cas, à l'étape 1114, il est vérifié que la broche est connectée à la cellule précédente. Si tel est le cas, l'étape 1110 est remise en oeuvre. Si la réponse au test effectué à l'étape 1114 est négative, il est vérifié à l'étape 1116 que la broche considérée est une broche de sortie. Si tel n'est pas le cas, une autre broche est choisie à l'étape 1110.

Si la broche considérée est une broche de sortie, l'étape 1118 est mise en oeuvre. Celle-ci consiste en l'appel de la fonction **sortie_cherche_noeuds ()** associés aux paramètres correspondants.

A l'issue de la fonction **sortie_cherche_noeuds (),** une nouvelle broche est choisie à l'étape 1110.

Lorsque appelée depuis l'étape 1118 et comme illustré sur la figure 12, la fonction **sortie_cherche_noeuds () dispose** comme variable d'entrée du pointeur de la cellule considérée 1202, du numéro de sortie du circuit intégré considérée 1204, du noeud de départ 1206, ainsi que du mode 1208. Ce dernier est fixé à 0 pour le marquage.

A l'étape 1210, il est d'abord vérifié que la cellule est une cellule d'entrée ou de sortie. Si tel est le cas, l'algorithme rebrousse chemin. Si tel n'est pas le cas, l'étape 1212 est mise en oeuvre au cours de laquelle une broche d'entrée de la nouvelle cellule est choisie.

Il est vérifié à l'étape 1214 que cette broche d'entrée existe. Si elle existe réellement, il est vérifié à l'étape 1216 que le noeud qui est connecté est déjà marqué. Si celui-ci est déjà marqué, et que le mode est à 0 lors du test effectué à l'étape 1218, une nouvelle broche d'entrée est choisie par une nouvelle mise en oeuvre de l'étape 1212.

Si le noeud considéré n'est pas déjà marqué, et que le mode est à 0 lors d'une vérification de l'étape 1220, ce noeud est marqué pour la sortie n considérée à l'étape 1222 et le compteur de noeuds de la sortie n est incrémenté. Enfin, à l'étape 1224, le choix d'une nouvelle broche d'entrée est effectué par appel de la fonction **noeud_cherche_sorties ().**

Les appels récursifs réciproques des fonctions **sorties_cherche_noeuds ()** et **noeud_cherche_sorties ()** permettent le parcours total des arbres associés à chacune des sorties, l'ensemble des sorties étant balayé par l'application de l'algorithme de marquage de la figure 10.

Ainsi s'achève la phase de marquage 108. A l'issue de celle-ci, commence la phase 110 de construction du sous-ensemble minimal et de numérotation.

Pour la construction du sous-ensemble minimal, l'état de fonctionnement des sorties du circuit à analyser doit être connu.

A cet effet, une séquence de tests appropriés est préalablement appliquée sur les entrées du circuit à analyser, afin de déterminer parmi les sorties du circuit celles sur lesquelles apparaît un signal satisfaisant ou correct et celles sur lesquelles apparaît un signal défaillant ou incorrect.

Ainsi, les sorties du circuit sont réparties en deux groupes. Le premier groupe des sorties satisfaisantes, est défini dans une liste dénommée SOK (Acronyme pour Sortie OK).

Les sorties du circuit considérées comme défaillantes sont régroupées dans une seconde liste dénommée SNOK (Acronyme pour Sortie Non OK).

Ces listes sont désignées par les références 112 et 114 dans l'organigramme de la Figure 1.

En résumé, à ce stade, les données d'entrée du programme sont :

- Le fichier de description du circuit sous la forme d'un ensemble de cellules et de noeuds d'interconnexion. Si ce fichier est à l'un des formats Edif (extensions « .edf, .edn ou .edo »), le programme lance automatiquement un interpréteur (parser). Le circuit peut également être décrit en utilisant le format interne de description (extension « .parsed »). Ce dernier format permet d'accéder à un niveau hiérarchique arbitraire de définition des cellules sans passer par les contraintes de l'Edif.
- La liste des sorties trouvées défaillantes à un moment donné de la séquence de test (SNOK).
- Une liste (facultative) de sorties qui n'ont jamais été trouvées défaillantes pendant le déroulement de la séquence de test (SOK).

A l'étape 212, l'algorithme détermine l'arbre de référence, c'est-à-dire l'arbre dans lequel les fautes du circuit seront recherchées.

Parmi les cônes relatifs aux sorties SNOK, il en existe au moins un qui contient le plus petit nombre de noeuds. Ce cône particulier est le cône de référence. C'est dans ce cône que seront recherchées les fautes. Ceci est exposé dans les paragraphes qui suivent.

Le programme.sélectionne, pour la sortie de référence, la sortie défaillante dont le cône d'influence contient le plus petit nombre de noeuds. Ces nombres de noeuds sont contenus dans le tableau commun totalSorties[].

Un fois connue la sortie de référence, la fonction **noeud_cherche_sorties()** est exécutée avec la valeur 1 pour le paramètre « mode ».

Le mécanisme de construction de l'arbre de référence est analogue à celui du marquage.

Cependant :

- Au lieu d'utiliser des tableaux de marqueurs, on utilise un champ scalaire « référence » de chaque structure NOEUD pour mémoriser l'appartenance d'un noeud à l'arbre de référence.
- On affecte à chaque noeud de l'arbre de référence une liste de parents. Le champ « liste_parents » dans chaque structure NOEUD est un pointeur sur le début de la liste de parents associée à ce noeud. Un élément de liste de parents contient un pointeur vers le noeud parent. Un pointeur sur la cellule liant le noeud à ce parent et un témoin indiquant si ce parent est une coupure ou non.

Les éléments de liste de parents sont décrits dans le fichier d'en-tête « structures.h ».

Les étapes spécifiques à la construction de l'arbre de référence figurent en gras sur la figure 12.

En particulier, lors de la construction de l'arbre de référence, le test effectué à l'étape 1216 détermine si le noeud connecté à la broche choisie a été ou non référencée. Si tel est le cas, après l'étape 1218 où il est vérifié que le mode est égal à 1, l'étape 1240 est mise en oeuvre. Elle consiste à ajouter un parent au noeud de départ en tant que coupure. A l'issue de cette étape, une nouvelle broche d'entrée est choisie à l'étape 1212.

Si lors du test effectué à l'étape 1216, il est constaté que le noeud qui est connecté à la broche d'entrée n'a pas déjà été référencé, et que le mode est égal à 1 lors du test effectué à l'étape 1220, l'étape 1242 est mise en oeuvre. Lors de cette étape, le noeud considéré est référencé et ce noeud est ajouté à la liste des parents du noeud de départ.

A l'issue de cette étape, l'appel à la fonction **noeud_cherche_sort!es** () est à nouveau effectué à l'étape 1224.

Le sommet de l'arbre de référence est le noeud d'entrée de la cellule de sortie associée à la sortie de référence.

La décomposition du graphe d'influence en arbres n'est pas unique. Elle dépend, en particulier, de l'ordre d'enregistrement des parents dans les listes de parents. Cependant ceci ne semble pas induire de problème particulier au niveau de la méthode.

Les étapes suivantes, notées 214 à 220, de là phase 110 de construction du sous-ensemble minimal consistent à construire le plus petit sous-ensemble de noeuds contenant les pannes et dans lequel s'effectuera la recherche proprement dite de fautes. Ce sous-ensemble est dénommé "sous-ensemble minimal".

Le sous-ensemble minimal est un sous-graphe de l'arbre de référence. Sa méthode de construction est donnée ci-dessous.

Lorsque une ou plusieurs fautes affectent simultanément un groupe de sorties, leur position est à rechercher dans le sous-ensemble formé par l'intersection des cônes d'influence de ces sorties.

Ce sous-ensemble est noté : $\bigcap_i SNOKi$

où SNOKi est le cône d'influence de la sortie d'indice de la liste SNOK.

Un sous-ensemble constitué par la réunion des cônes d'influence de sorties non défaillantes correspond à un ensemble de noeuds qui ne sont pas des points de propagation de fautes.

Un sous-ensembie de ce type est noté: $\bigcup_j SOKj$

où SOKj est le cône d'influence de la sortie d'indice j de la liste SOK.

Un sous-ensemble $\bigcup_j SOKj$ a, en général, une intersection non vide avec le sous-ensemble $\bigcap_i SNOKi$

On peut donc réduire la recherche en éliminant de $\bigcap_i SNOKi$ cette intersection.

On obtient alors le "sous-ensemble minimal" noté SM dans lequel seront effectuées toutes les recherches de fautes.

Du point de vue formel, on a :

$$SM = \bigcap_i SNOKi - \left(\bigcap_i SNOKi \cap \bigcup_j SOKj\right)$$

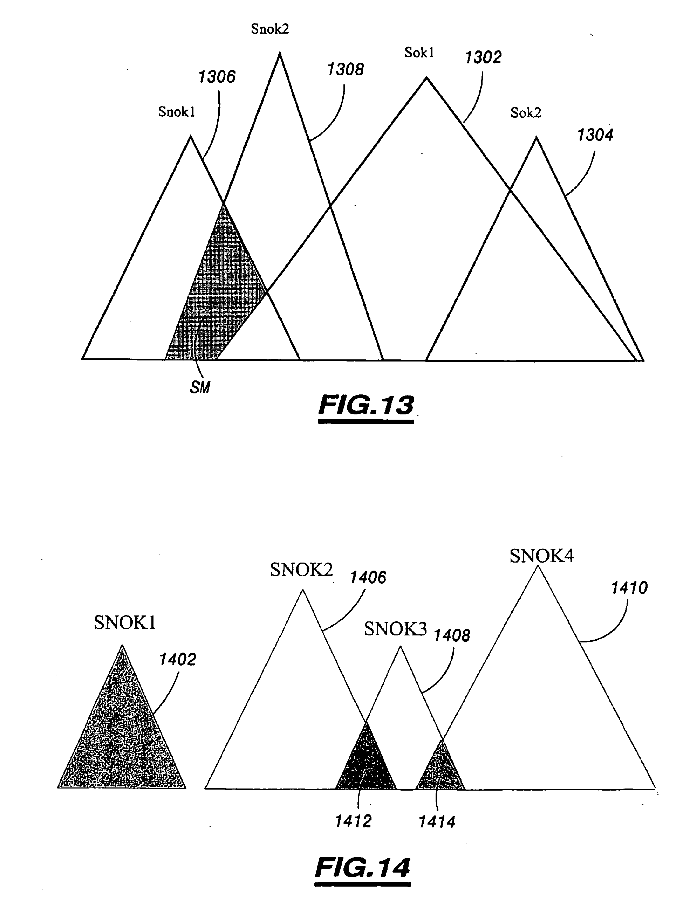

Le sous-ensemble SM est illustré sur la figure 13 en considérant deux cônes notés 1302 et 1304 correspondant à des sorties correctes SOK1 et SOK2 et deux cônes notés 1306 et 1308 correspondant à des sorties incorrectes SNOK1 et SNOK2.

Le sous-ensemble minimal SM trouvé a la structure d'un ensemble d'arbres disjoints. Les sommets de ces arbres sont réunis à un noeud virtuel de manière à ce que les algorithmes de recherche appliqués par la suite n'aient à manipuler qu'un seul arbre.

Pour une liste donnée de sorties défaillantes, la construction de l'intersection $\bigcap_i \bigcap_i SNOKi$ se fait en recherchant l'ensemble des noeuds qui influencent simultanément toutes les sorties de la liste.

Il peut donc se faire que l'intersection des sorties défaillantes conduise à un sous-ensemble vide.

Tel est le cas si les sorties défaillantes ont des cônes disjoints ou bien si l'intersection est non connexe comme illustré sur la figure 14. Dans ce cas, il y a plusieurs zones défaillantes indépendantes.

Dans le cas particulier de la figure 14, les cônes 1402, 1406, 1408, et 1410 sont chacun associés à une sortie défaillante du circuit intégré. Le cône 1402 est disjoint des cônes 1406 à 1410, ces trois derniers cônes présentent des intersections.

On constate, par les zones hachurées sur la figure 14, que l'intersection des cônes 1406 à 1410 forme deux ensembles disjoints notés 1412 et 1414 alors que le cône 1402 constitue lui-même une zone défaillante dont l'étendue ne peut être réduite puisque celui-ci ne possède pas d'intersection avec les autres cônes associés à des sorties défaillantes.

Le programme est adapté pour détecter ces cas particuliers et fractionne la liste des sorties défaillantes de manière à ce que pour chaque fraction de liste l'intersection trouvée par le programme soit connexe et minimale.

Pour explorer correctement ces zones, l'opérateur doit re-exécuter le programme sur chacune des fractions de liste proposées.

Dans un sous-ensemble connexe, le programme est adapté pour traiter des fautes multiples, sauf si ces fautes interagissent et se corrigent mutuellement, par exemple.

Afin de construire le sous-ensemble minimal, on construit d'abord à l'étape 214 des listes de masques.

A partir des listes de sorties SNOK et SOK, on construit deux listes de masques dont les adresses des premiers éléments sont contenues.dans les pointeurs : masque_NOK et masque_OK.

Un élément de ces listes est une structure dont le type (MASQUE) est prédéfini dans l'en-tête « structures.h ». Le champ « masque » de ces structures est un entier du type prédéfini (TYPEMASQUE).

Il sert à coder les sorties citées dans la liste de sorties et relatives à un même groupe. Ce groupe est mémorisé dans la même structure par le champ « groupe » qui est un entier ordinaire (int).

Le principe du codage des sorties dans un masque est identique à celui adopté pour les marqueurs. Le nombre d'éléments d'une liste de masques est donc le nombre de groupes nécessaires pour repérer les sorties citées dans la liste de sorties associée. La correspondance entre le numéro de sortie et le groupe est déjà mémorisée dans le tableau groupeSortie[ ] cité précédemment.

Les champs « masques » de ces listes de masques sont destinés à être comparés au contenu des marqueurs du même groupe de chacun des noeuds pour la réalisation des opérations d'intersection et d'exclusion.

Pour que le mécanisme de marquage fonctionne, on ne doit pas avoir de référence multiple à une même sortie dans les liste de sorties.

Pour la construction de la liste masque_NOK, il ne faut pas tenir compte de la sortie choisie comme référence puisque c'est dans son cône que sera recherchée l'intersection.

Les différentes opérations d'intersection et d'exclusion nécessaires à la construction du sous-ensemble minimal se font en comparant les marqueurs des noeuds *de l'arbre de référence* avec les masques construits à partir des listes SNOK et SOK.

A l'étape 216, on procède ensuite à l'intersection des listes des SNOK.

Pour décider si un noeud est inclus dans l'intersection des listes des SNOK, on compare, pour chaque élément de la liste « masqueSnok », la valeur du masque et le marqueur relatif au même groupe associé à ce noeud.

Si le noeud appartient à l'intersection, tous les bits égaux à un dans les masques doivent l'être dans les marqueurs correspondants pour tous les groupes de la liste « masqueSnok ».

La comparaison se fait en utilisant le ET logique.

Ceci consiste, pour chaque élément de la liste de masques, à tester l'exactitude de la condition suivante : valeur_marqueur(groupe) & valeur_masque valeur-masque.

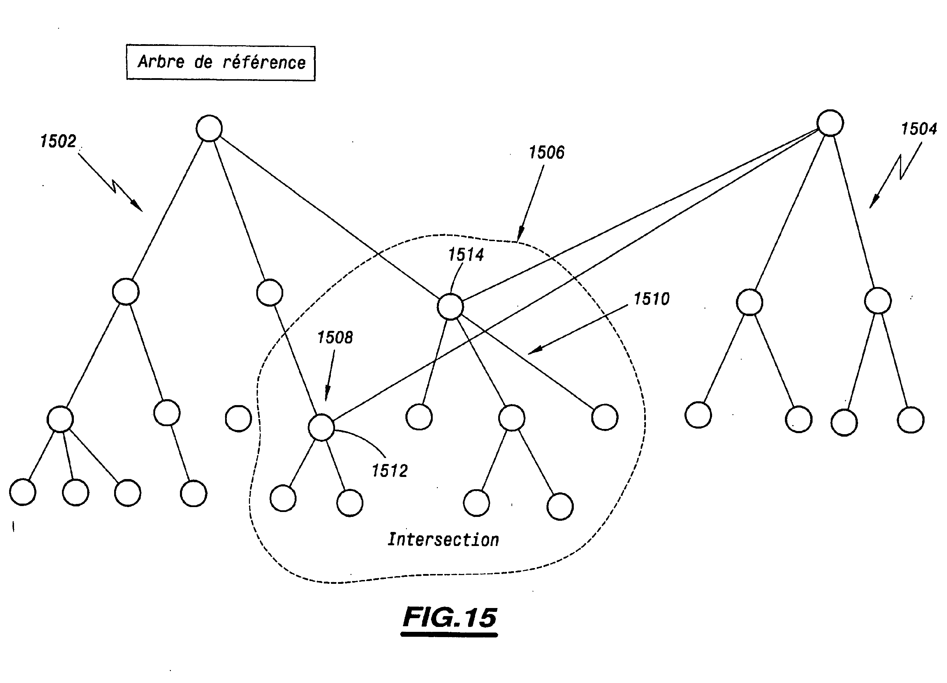

Sur la figure 15 est représenté, d'une part, l'arbre de référence noté 1502 et, d'autre part, un autre arbre 1504 associés à une sortie incorrecte.

L'intersection des deux arbres notée 1506 est entourée d'une ligne pointillée. On constate sur cette figure, que la structure de l'intersection est celle d'un ensemble de sous-arbres 1508 et 1510, dont les sommets 1512 et 1514 respectivement sont reliés par un arc orienté à au moins un noeud de chacun des arbres 1502 et 1504.

La structure de l'intersection est celle d'un ensemble de sous-arbres disjoints de l'arbre de référence. Si ces arbres n'étaient pas disjoints, il existerait dans l'arbre de référence au moins un cycle, ce qui est impossible, par construction.

Pour définir l'intersection 1506, il suffit donc de savoir énumérer les sommets 1512 et 1514 de ces arbres.

Pour trouver les sommets de ces arbres, on parcourt l'arbre de référence depuis son sommet avec une procédure standard. Dés qu'on trouve un noeud qui appartient à l'intersection, il s'agit d'un sommet ; on l'enregistre dans une liste et l'algorithme rebrousse chemin comme s'il s'agissait d'une terminaison.

Les coupures interrompent également la descente mais ne sont pas prises en compte en tant que sommet. S'il y a lieu, leur jumeau peut être pris comme sommet quand il est analysé.

La méthode exposée dans le paragraphe précédent consiste à rechercher l'ensemble des noeuds qui influencent simultanément toutes les sorties de la liste des SNOK.

Il peut donc se faire que l'intersection trouvée soit vide. Ceci est le cas si les sorties défaillantes ont des cônes disjoints ou bien si l'intersection est non connexe comme dans le cas de la figure 14.

Lorsque l'intersection trouvée est vide, le programme recherche à l'étape 218 les intersections minimales connexes.

Ces sous-ensembles sont les intersections de cônes qui ne contiennent plus aucune autre intersection.

Avant de rechercher ces sous-ensembles, il est nécessaire de reconstruire la liste (interne) des SNOK et celle des masques_NOK afin de tenir compte de la sortie qui avait été prise comme référence.

Ensuite, la recherche s'effectue en trois phases.

**La première phase** consiste à rechercher la liste de tous les sous-ensembles qui font intervenir au moins une sortie de la liste SNOK dans leur définition (liste primaire).

Un sous-ensemble est repéré par le marqueur du noeud courant de ce sous-ensemble.

Cette liste est obtenue en balayant la liste des noeuds. Pour chaque noeud, on fait le ET logique entre les composantes du marqueur et leur homologue (de même numéro de groupe) de la liste masque_NOK. Si au moins un des résultats de ces ET est non nul, le marqueur de ce noeud définit un sous-ensemble pertinent. On vérifie si ce sous-ensemble n'a pas déjà été trouvé avant de l'enregistrer.

A la fin de cette étape, la liste primaire contient donc la désignation de tous les sous-ensembles formés à partir des cônes des SNOK. Chacun des sous-ensembles y figure de manière unique.

Du point de vue de la programmation, cette liste est une liste de structures de type « listeTableauxMasques ». Le champ « masque » de ces structures est un pointeur sur le tableau d'entiers de type (TYPEMASQUE) contenant, pour chaque groupe, le résultat des opérations ET citées ci-dessus.

Le champ « inclusion » sert, dans la seconde phase, à indiquer si le sous-ensemble contient un autre sous-ensemble.

**La seconde phase** consiste à comparer chaque élément de la liste primaire avec les autres.

La comparaison consiste à tester, pour chaque groupe, les conditions suivantes :

$$(\text{masque\_du\_sous-ensemble\_A}) \,\&\, (\text{masque\_du\_sous-ensemble\_B})$$
$$== (\text{masque\_du\_sous-ensemble\_A}).$$

Si pour tous les groupes cette condition est vraie, le sous-ensemble B est inclus dans A et A doit être rejeté puisqu'il ne peut, dès lors, être une intersection minimale. Pour signifier ce rejet, on met à un le champ inclusion de la structure décrivant le sous-ensemble A.

A la fin de cette phase, les éléments de la liste dont le champ inclusion n'a pas été mis à un sont les intersections minimales connexes recherchées.

Si « n » est le nombre de sorties de la liste SNOK, le nombre total de comparaisons à effectuer est égal à n(n-1).

**La troisième phase** consiste à passer en revue tous les éléments de la liste primaire et, pour ceux dont le champ « inclusion » est nul, à construire, à partir du champ « masque », un fichier texte contenant la liste des noms de sorties relatifs à ce sous-ensemble.

Chaque fichier issu du fractionnement du fichier des SNOK initial porte un nom construit de la manière suivante : « nomListeInitialeSNOK_fraction_numéro snok ». Le programme devra être relancé pour chacune de ces fractions de la liste initiale.

L'étape suivante, notée 220, consiste en l'exclusion des SOK et des entrées.

Il s'agit de retirer de l'intersection les noeuds qui appartiennent à l'USOK (réunion des cônes des SOK).

Dans le programme, on distingue les exclusions exhaustives et non exhaustives.

Pour la construction du sous-ensemble minimal, on utilise le mode « non exhaustif ».

Dans ce mode, on parcourt chacun des arbres de l'intersection et lorsqu'un noeud appartient à la réunion des SOK, on met à « un » le champ « exclusion » dans la structure NOEUD qui lui est attachée.

Le parcours se fait avec l'algorithme « à ordre préfixé » les coupures sont des points de rebroussement et leur jumeau peut être exclu s'il appartient à l'USOK.

Pour déterminer si un noeud appartient à l'USOK, pour chaque élément de la liste masque_OK, on compare la valeur du masque avec l'élément (de même numéro de groupe) du tableau de marqueurs associé à ce noeud. La comparaison utilise le ET logique. Si pour l'une au moins de ces comparaisons les deux entiers ont un bit homologue égal à un, le noeud appartient à l'USOK. Il s'agit donc de tester l'exactitude des conditions suivantes : valeur_marqueur (groupe) & valeur_masque != 0.

L'exclusion des noeuds connectés à la sortie des cellules d'entrée se fait, de façon triviale, en balayant la liste des broches du composant.

A l'étape 222, est défini un sommet virtuel.

Les sommets du sous-ensemble minimal sont reliés à un noeud virtuel.

La variable globale « sommet_virtuel » est un pointeur sur ce noeud.

La fonction « **créer_un_pseudo_sommet( )** » crée ce noeud et initialise ses champs.

La numérotation du sous-ensemble minimal, réalisée à l'étape suivante notée 224, consiste à mémoriser dans le champ « compteur_ancêtres » de chaque noeud le nombre total de ses ancêtres.

On attribue aux noeuds exclus et aux coupures un nombre d'ancêtres nul.

Un noeud exclu offre une contribution nulle à son successeur.

Une coupure offre une contribution d'une unité à son successeur.

Les parents d'un noeud sont ses ancêtres immédiats (directement rattachés).

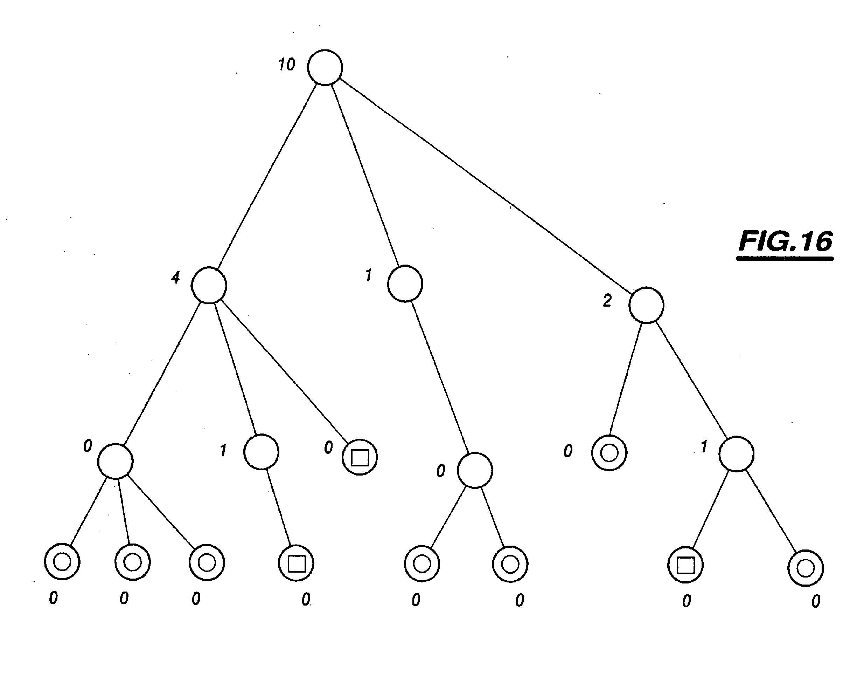

La figure 16 donne un exemple de numérotation.

Cette numérotation est utilisée dans l'algorithme de localisation pour proposer des choix de noeud à tester.

Pour effectuer la numérotation d'un arbre, on parcourt une première fois cet arbre avec l'algorithme standard à ordre préfixé et on attribue aux champs « compteur_ancêtres » la valeur nulle (phase d'initialisation). Dans une seconde phase, on refait le parcours avec l'algorithme à ordre post-fixé et on attribue au compteur d'ancêtres de chaque noeud la valeur :

(somme des compteurs d'ancêtres des parents de ce nœud + nombre de parents du nœud)

La phase suivante du procédé désignée par la référence générale 124 sur la figure 1 consiste en la recherche des fautes par dichotomie dans le sous-arbre minimal.

A cet effet, on détermine d'abord, à l'étape 230, suivant un critère qui sera explicité dans la suite, un nœud moyen dans le sous-arbre minimal puis on effectue à l'étape 232 un test physique sur ce noeud si ce noeud est testable. Pour évaluer si le noeud est testable, une vérification est effectuée à l'étape 233. Si la réponse est négative, plutôt que de solliciter le testeur en 232, un appel à la phase 126 du procédé est effectué.

L'algorithme de dichotomie assure la convergence de la recherche vers une ou plusieurs zones défaillantes. Le principe simplifié est le suivant:

L'algorithme propose un test sur un noeud interne du domaine de recherche.

Ce noeud est choisi de telle sorte que le nombre de ses ancêtres soit approximativement égal à la valeur moyenne du nombre d'ancêtres des noeuds du domaine de recherche, non encore testés.

Si le signal sur ce noeud est normal, ce noeud est éliminé de la recherche ainsi que tous ses ancêtres.

Ceci est basé sur l'hypothèse selon laquelle si un noeud n'est pas un point de propagation de faute, ses ancêtres, qui sont les noeuds susceptibles de l'influencer ne le sont pas non plus.

On obtient donc ainsi une réduction, à caractère exponentiel, de la zone de recherche.

Si le signal sur le noeud testé est anormal, c'est que ce noeud appartient à une zone défaillante. Il est alors pris comme nouveau point de départ des recherches.

Comme certains noeuds ne sont pas testables et que les noeuds trouvés mauvais ne sont pas forcément des sommets de zones défaillantes, des tests de cohérence sont nécessaires avant de pouvoir déterminer les limites d'une zone défaillante. La présence de ces tests de cohérence, imbriqués dans la dichotomie, complique singulièrement l'algorithme. Celui-ci est décrit en détail dans la suite de la description.

Le sous-ensemble minimal dans lequel les fautes sont recherchées est un ensemble d'arbres disjoints. Les sommets de ces arbres forment la liste des parents d'un noeud virtuel destiné à manipuler le sous-ensemble minimal de façon globale.

En fonction du moyen de test utilisé, on spécifie une profondeur limite de testabilité des noeuds (profondeur_maxi).

Suivant l'implantation du circuit (désignée par "layout" en anglais), la profondeur limite spécifiée peut rendre une partie des noeuds non-testables (y compris les parents du noeud virtuel).

On peut, de plus, déclarer une partie des noeuds non-testables indépendamment de leur profondeur.

Les terminaisons, testables ou non, du sous-ensemble minimal peuvent être :

• Des coupures ;
• Des noeuds de sortie de cellules d'entrée (déjà exclus) ;
• Des noeuds frontières d'USOK (déjà exclus).

A chaque noeud est affectée une variable contenant le nombre total de ses ancêtres. Les coupures et les noeuds d'entrée ont un nombre d'ancêtres nul.

Les caractères du noeud virtuel sont, par convention:

• Non-testable

• Défaillant

• Non exclu

En outre, les données suivantes sont également mises en oeuvre par le programme:

• La liste des noeuds internes déjà testés (liste facultative). Cette liste est complétée automatiquement par le programme au fur et à mesure que des nouveaux tests sont effectués. Si elle est inexistante, le programme la crée.
• Une liste (facultative) de noeuds que l'opérateur, pour des raisons diverses, considère comme non-testables.
• Le fichier donnant le "niveau métal" de chacun des noeuds internes à tester (facultatif). Tout noeud non cité dans cette liste est considéré, par défaut, comme étant au niveau "métal 1". Si la liste n'existe pas, tous les noeuds sont considérés comme étant au niveau "métal 1".

En effet, un noeud donné est toujours situé sur une "piste" d'interconnexion. En général, les pistes d'interconnexion sont réparties sur des "niveaux" situés à différentes profondeurs. Ces niveaux d'interconnexion sont séparés par des couches isolantes (SiO2, Si3N4, etc....).

Le premier niveau d'interconnexion appelé "métal 1" est, par convention, celui qui est le plus proche de la surface. Le dernier est celui qui est le plus proche du semi-conducteur. Le programme supporte 253 niveaux mais on pourrait étendre ce nombre sans problème.

Mesurer l'état d'un noeud à partir d'un testeur suppose que ce testeur sache sonder le circuit jusqu'à la profondeur d'interconnexion associée à ce noeud. Pour un testeur donné, il existe donc une limite de visibilité des noeuds. Cette limite de testabilité est appelée "profondeur maximale de test" (variable "profondeur_maxi" dans le code). Elle doit être spécifiée par l'utilisateur suivant le moyen de test utilisé.

Les fichiers, facultatifs, dont on dispose sont:

- Un fichier donnant la profondeur des noeuds (niveau métal = 1 par défaut)
- Un fichier de noeuds non-testables (seuls les noeuds spécifiés sont non-testables)
- Un fichier de noeuds déjà testés (créé par le programme s'il est inexistant)

Les paramètres de recherche sont :

- La profondeur maximale de test
- Le critère d'arrêt des recherches (une cellule défaillante ou une zone défaillante ou toutes les parties défaillantes).

L'algorithme de recherche est basé sur le principe de dichotomie. Il assure, généralement, la convergence de la recherche vers une ou plusieurs zones défaillantes.

L'algorithme propose un test sur un noeud interne du domaine de recherche. Ce noeud est choisi de telle sorte que le nombre de ses ancêtres soit approximativement égal à la valeur moyenne du nombre d'ancêtres des noeuds du domaine de recherche, non encore testés. Le noeud choisi est dit "noeud moyen".

Ce noeud doit, de plus, satisfaire les contraintes suivantes :

- Il doit être testable ;
- Ne pas avoir déjà été trouvé défaillant
- Ne doit pas être un sommet de zone défaillante
- Ne doit pas être exclu
- Ne doit pas être l'ancêtre-d'un noeud exclu après test
- Ne doit pas être l'ancêtre d'un sommet de zone défaillante

La réponse concernant le résultat du test du signal sur ce noeud peut être fournie automatiquement par le testeur ou bien entrée au clavier par l'opérateur.

Si le signal sur ce noeud est normal, ce noeud est éliminé de la recherche ainsi que tous ses ancêtres.

Pour éliminer ce noeud, on l'exclut, ainsi que tous ses ancêtres, en mettant à un les champs « exclusion » des structures de données associées à ces noeuds (exclusion dite exhaustive). Une fois cette exclusion opérée, on renumérote (en nombre d'ancêtres) le sous-ensemble minimal depuis le sommet virtuel, de telle sorte que le nouveau calcul de noeud moyen ne tienne plus compte des nouveaux noeuds exclus.

Si le signal sur le noeud testé est anormal, c'est que ce noeud est en aval d'une zone défaillante. Il est alors pris comme nouveau point de départ des recherches.

La technique de programmation adoptée est récursive. La même fonction est utilisée avec certains paramètres d'entrée hérités du contexte précédent. Notamment, le sommet de la recherche est maintenant le noeud dont le signal a été déclaré mauvais.

On n'effectue pas de récurrence sur une coupure. On se contente de la marquer mauvaise si le signal est mauvais sur son noeud jumeau.

Au retour de chaque récurrence, suivant les décisions prises relativement au critère d'arrêt spécifié, on peut sortir de la fonction ou bien continuer à chercher parmi les noeuds proposables non encore testés.

Lorsque la recherche doit se poursuivre, c'est-à-dire que l'on souhaite trouver toutes les zones défaillantes ou bien que les noeuds testés mauvais et les tests de cohérence effectués ne permettent pas, à ce stade, de déclarer une zone défaillante.

Des tests de cohérence sont nécessaires avant de pouvoir déterminer les limites d'une zone défaillante.

Ceci est lié au fait que certains noeuds ne sont pas testables et que les noeuds trouvés mauvais ne sont pas forcément des sommets de zones défaillantes.

Les tests de cohérence et les tests d'exactitude du critère d'arrêt spécifié sont effectués lors de la phase 126 d'"analyse après épuisement".

Le premier appel de l'algorithme de recherche est fait depuis le sommet virtuel du sous-ensemble minimal. La zone de recherche initiale est donc le sous-ensemble minimal.

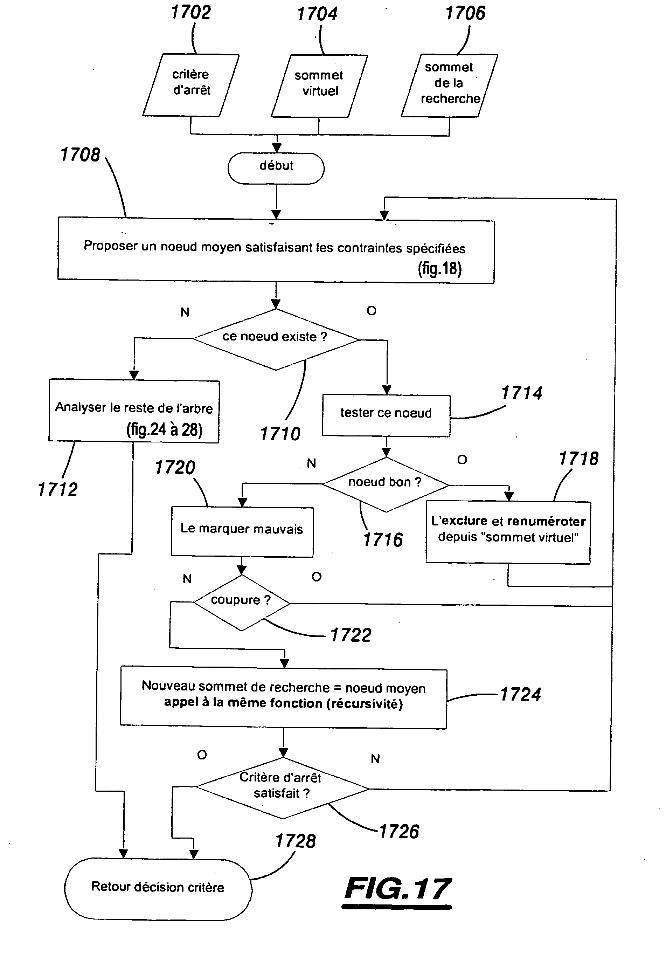

L'algorithme de recherche constituant la fonction **dichotomie( )** est explicité dans l'organigramme de la figure 17.

La fonction **dichotomie ()** reçoit en entrée le critère d'arrêt 1702, le sommet virtuel 1704 de l'arbre sur lequel elle opère ainsi que le sommet 1706 de la recherche.

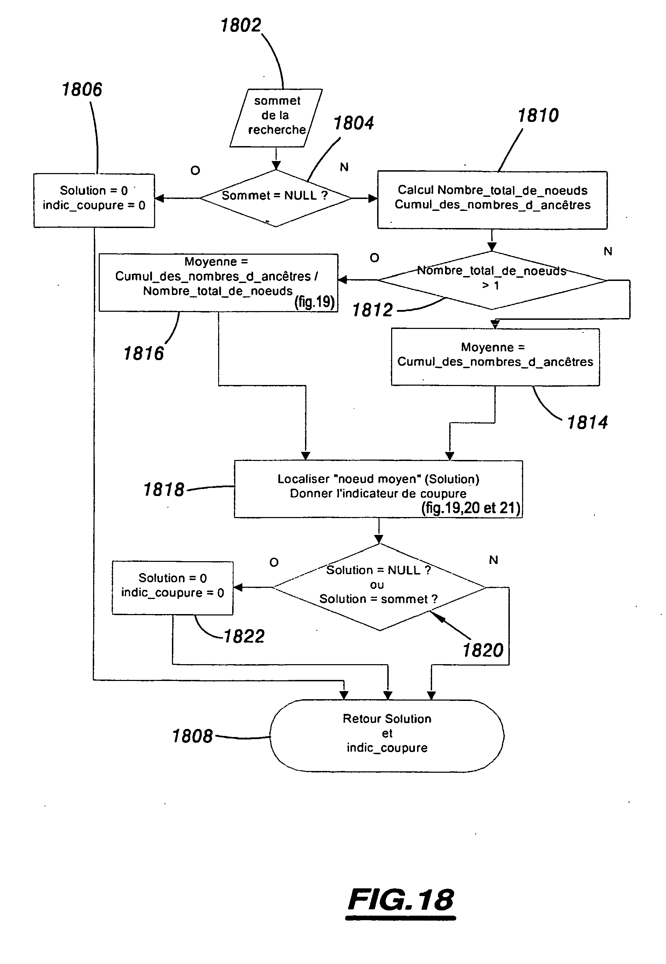

A l'étape 1708, un noeud moyen satisfaisant les contraintes spécifiées est proposé. Ce noeud moyen est déterminé comme cela sera expliqué ultérieurement par une mise en oeuvre de la fonction **chercher_noeud_moyen ()** exposée en regard de la figure 18.

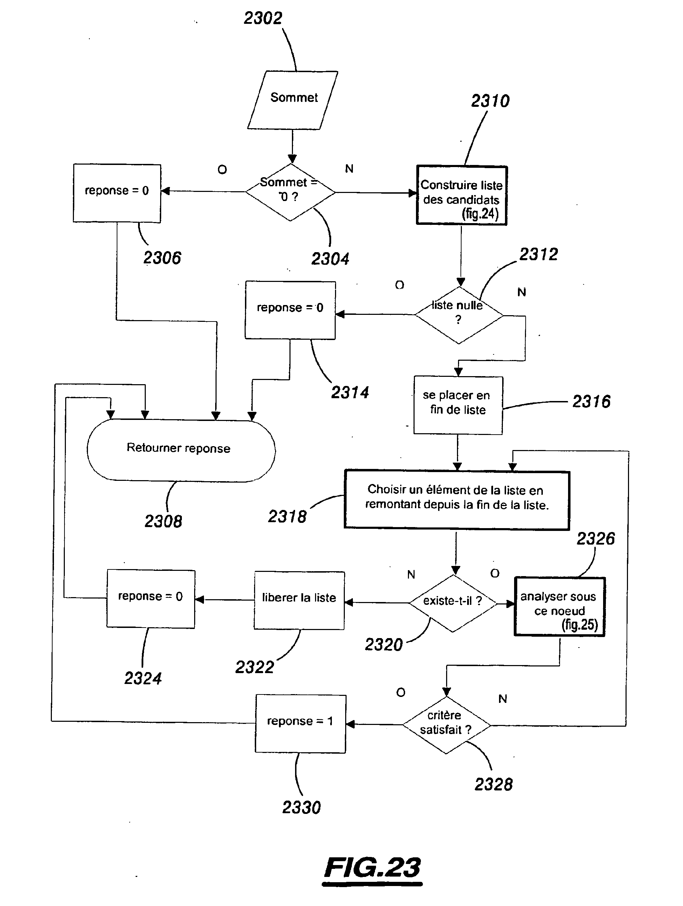

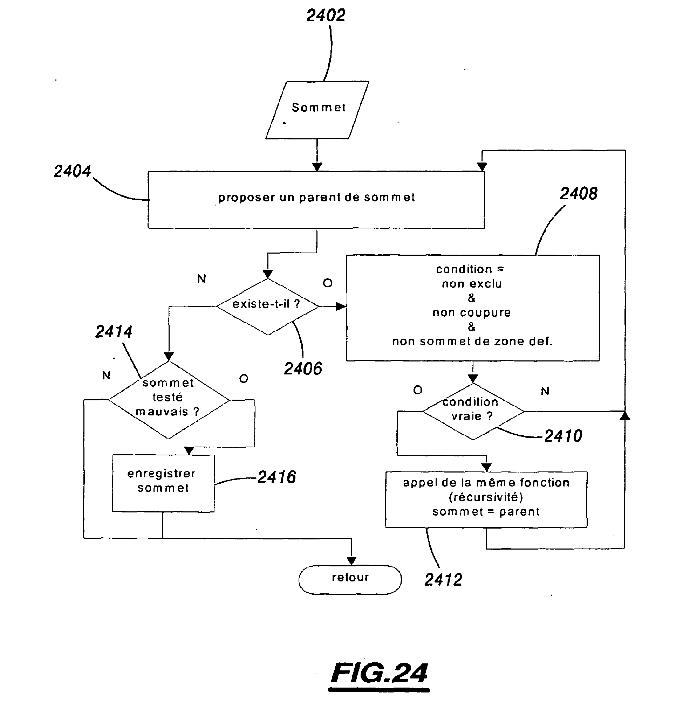

Il est vérifié à l'étape 1710 que ce noeud moyen existe. Si tel n'est pas le cas, l'étape 1712 est mise en oeuvre au cours de laquelle le reste de l'arbre est analysé sans mise en oeuvre du testeur. A cet effet, la fonction **analyser_cellules_restantes ()** est mise en oeuvre pour tenter de fractionner l'ensemble des noeuds restant en zone défaillante. La fonction **analyser_cellules_restantes ()** sera décrite ultérieurement en regard de la figure 23 en tenant compte des algorithmes qu'elle met en oeuvre et qui sont décrits aux figures 24 à 28.

Si par contre, il est révélé à l'étape 1710 qu'un noeud moyen satisfaisant les contraintes spécifiques existe, ce noeud est testé à l'étape 1714 par mise en oeuvre du testeur.

A cet effet, une séquence de tests prédéterminés est appliquée aux bornes d'entrée du circuit intégré et le signal obtenu au point de mesure correspondant au noeud moyen déterminé à l'étape 1708 est mesuré et comparé au signal théorique devant être obtenu en ce point.

Si le signal mesuré est identique au signal théorique devant être obtenu, le noeud est considéré comme bon. Sinon, le noeud est considéré comme mauvais.

Suite aux tests opérés à l'étape 1716, si le noeud est bon, celui-ci est exclu à l'étape 1718 et l'arbre de recherche est numéroté depuis le sommet virtuel défini en 1704. L'étape 1708, ainsi que les étapes ultérieures sont remises en oeuvre sur la seule partie de l'arbre obtenue après exclusion du noeud moyen précédemment testé.

Si par contre à l'étape 1716, le noeud est détecté comme mauvais, celui-ci est marqué comme mauvais à l'étape 1720. L'étape ultérieure 1722 consiste à vérifier si le noeud marqué mauvais est ou non une coupure. Si tel est le cas, un autre noeud de l'arbre est testé par une nouvelle mise en oeuvre des étapes 1708 et suivantes.

Par contre, si le noeud marqué mauvais n'est pas une coupure, ce noeud devient à l'étape 1724 le nouveau sommet de recherche servant à une nouvelle mise en oeuvre récursive de la fonction **dichotomie ()** appliquée avec comme nouveau sommet de recherche en 1706 le noeud moyen précédemment considéré comme mauvais.

A l'issue de l'application récursive de la fonction dichotomie () à l'étape 1724, il est testé à l'étape 1726 si le critère d'arrêt considéré en 1702 est ou non satisfait. Tant que ce critère n'est pas satisfait, de nouveaux noeuds moyens sont proposés à l'étape 1708 et testés aux étapes ultérieures. Dès que le critère d'arrêt est satisfait à l'étape 1726, il est mis un terme à l'étape 1728 à la fonction dichotomie et le résultat de l'analyse est mise à la disposition de l'utilisateur.

La recherche du noeud moyen opérée à l'étape 230 de la figure 2 correspondant à l'étape 1708 de la figure 17 s'effectue en deux phases.

Dans la première phase notée 234, on parcourt l'arborescence dans laquelle s'effectue la recherche et on calcule la valeur moyenne du nombre d'ancêtres.

Dans la seconde phase notée 236, on reparcourt l'arborescence et on cherche le noeud dont le nombre d'ancêtres est le plus proche, inférieurement, de la valeur moyenne calculée à l'issue de la première phase.

Un indicateur de coupure du noeud moyen proposé est également donné.

La fonction **chercher_noeud_moyen () qui** assure la coordination de ces deux phases est décrite en regard de la figure 18 dans l'organigramme du calcul et de la localisation du noeud moyen. Les fonctions relatives aux deux phases sont décrites dans les paragraphes suivants, respectivement au regard de la figure 19 et des figures 19, 20 et 21.

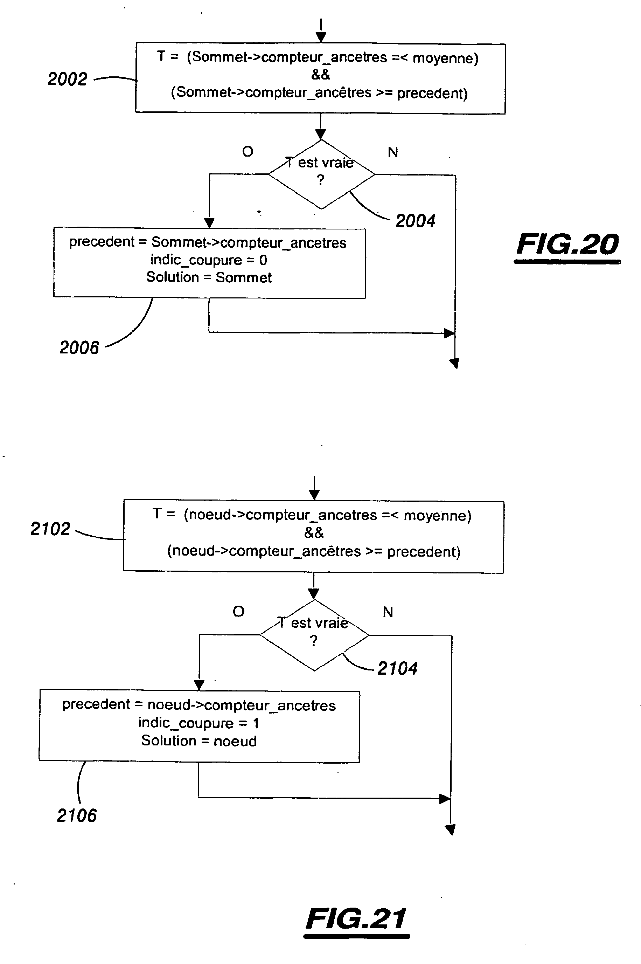

La fonction **chercher_noeud_moyen ()** mise en oeuvre à l'étape 1708, dispose en entrée, en 1802, du sommet de la recherche, c'est-à-dire du sommet de l'arbre dans lequel la recherche du noeud moyen est effectuée. A l'étape 1804, un test est effectué pour déterminer si ce sommet est NULL, c'est-à-dire si l'arbre est vide. Si tel est le cas, à l'étape 1806, la variable solution est fixée à 0, ainsi que la variable indic_coupure. Le résultat de la fonction est retourné à l'étape 1808 avec les valeurs associées à solution et indic_coupure. Les définitions de solution et indic_coupure seront données dans la suite de la description en référence aux figures 20 et 21.

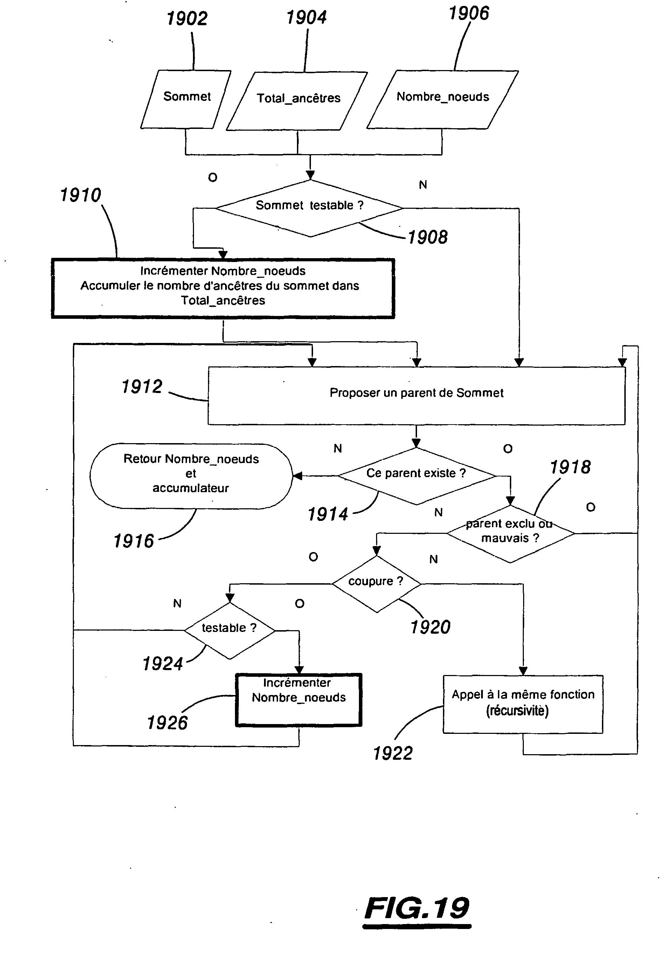

En revanche, si l'arbre n'est pas vide, c'est-à-dire que le sommet testé à l'étape 1804 est non nul, l'étape 1810 est mise en oeuvre par application de la fonction **calcul_moyenne ()** qui sera décrite en référence à la figure 19. Lors de cette étape, le nombre total de noeuds de l'arbre est calculé par à un parcours de celui-ci. De même, le calcul du cumul des nombres d'ancêtres est effectué. Le résultat de ces calculs est mémorisé respectivement dans les variables nombre_totat_de_noeuds et cumul_des_nombres_d'_ancêtres.

Lors du test de l'étape 1812, le nombre_totat_de_noeuds est comparé par la valeur 1. Si le nombre_totat_de_ noeuds est égal à 1, la moyenne est prise égale au cumul_des_nombres_d'_ancêtres à l'étape 1814.

En revanche, si le nombre_total_de_noeuds est supérieur à 1, la moyenne est calculée à l'étape 1816.

Quel que soit le mode de calcul de la moyenne à l'étape 1814 ou 1816, l'algorithme procède à l'étape 1818 à la localisation du noeud moyen, permettant de déterminer la variable solution ainsi que l'indicateur de coupure noté indic_coupure. L'algorithme de localisation du noeud moyen sera décrit ultérieurement en référence à la figure 19 modifiée conformément aux figures 20 et 21.

A l'étape ultérieure 1820, la solution obtenue pour le noeud moyen à l'étape 1818 est comparée aux valeurs particulières NULL et sommets. Si la variable solution est égale à l'une de ces valeurs, les variables solution et indic_ coupure sont fixées à 0 à l'étape 1822. Dans tous les cas, l'étape 1808 est enfin mise en oeuvre mettant à disposition le résultat de la fonction re**cherche_noeud_moyen ()**.

La fonction **calcul_moyenne ()** décrite sur la figure 19 dispose en entrée du sommet 1902 de l'arbre considéré, du total des ancêtres de cet arbre 1904, ainsi que nombre de noeuds 1906 de l'arbre considéré.

A l'étape 1908, il est vérifié que le sommet considéré en 1902 est testable. Si tel est le cas, à l'étape 1910, la variable nombre_noeuds est incrémentée et le nombre d'ancêtres du sommet est cumulé dans la variable total_ancêtres.

Que le sommet considéré en 1902 soit ou non testable, l'étape ultérieure 1912 consiste à proposer un parent du sommet, ceci afin de parcourir progressivement l'arbre. Si lors du test effectué à l'étape 1914, il est constaté qu'il n'existe pas de parent au sommet considéré, il est mis un terme à la fonction calcul_moyenne () à l'étape 1916 et les résultats de la fonction à savoir la variable nombre_noeuds et l'accumulateur sont retournés.

En revanche, si lors du test de l'étape 1914, le parent proposé pour le sommet existe, il est vérifié à l'étape 1918 que ce parent est exclu ou mauvais. Si tel est le cas, l'étape 1912 est à nouveau mise en oeuvre.

Si tel n'est pas le cas, il est testé à l'étape 1920 que le parent considéré est ou non une coupure. S'il ne s'agit pas d'une coupure, la fonction calcul_moyenne () est mise en oeuvre de manière récursive à l'étape 1922. A l'issue de cette mise en oeuvre récursive, l'étape 1912 de proposition d'un autre parent du sommet considéré est à nouveau exécutée.

En revanche, si à l'étape 1920, il est conclu que le parent considéré est une coupure, il est vérifié à l'étape 1924 si cette coupure est ou non testable. Si elle n'est pas testable, un nouveau parent est proposé à l'étape 1912. Si cette coupure est testable, la variable nombre_noeuds est incrémentée à l'étape 1926, avant qu'un nouveau parent du sommet ne soit proposé à l'étape 1912.

Pour le calcul de la moyenne à l'étape 234 de la figure 2 correspondant à l'étape 1810 de la figure 18, on parcourt l'arbre et, pour chaque noeud pertinent, on cumule dans un accumulateur le nombre de ses ancêtres et on incrémente un compteur de noeuds.

On ignore les noeuds exclus ou testés mauvais ainsi que leurs ancêtres. La récurrence se produit sur les noeuds pertinents qui ne sont pas des coupures. Les coupures non testables sont ignorées. Les coupures testables ne donnent lieu qu'à l'incrémentation du compteur de noeuds (nombre d'ancêtres nul).

Pour le premier appel de la fonction, on initialise à zéro l'accumulateur et le compteur de noeuds.

Pour le premier appel, le sommet donné ne doit pas être un noeud exclu.

L'algorithme détaillé du calcul du nombre de noeuds et du cumul des ancêtres constituant la fonction calcul_ moyenne() est donné dans l'organigramme de la figure 19.

La procédure de localisation du noeud moyen à l'étape 236 de la figure 2 correspondant à l'étape 1818 de la figure 18 est semblable à la procédure précédente moyennant quelques adaptations.

Le nom de cette procédure est : **localiser_moyenne( ).**

Pour en obtenir l'organigramme de la fonction localiser_moyenne (), il suffit de remplacer l'étape 1910 par le bloc de la figure 20, et l'étape 1926 par le bloc de la figure 21.

D'autre part, les paramètres d'entrée sont : Sommet, moyenne, Solution, indic_coupure et « precedent ». Le paramètre « precedent » est la dernière meilleure valeur approchée trouvée pour le nombre d'ancêtres du noeud moyen. Le premier appel de la fonction se fait avec precedent = 0.

Solution est le meilleur noeud trouvé et indic_coupure son indicateur de coupure.

Les noeuds déjà déclarés comme sommets de zones défaillante ne sont pas proposés comme noeuds moyens puisqu'ils sont interprétés comme noeud mauvais et écartés.

Plus précisément, et comme représenté sur la figure 20, lorsqu'à l'étape 1908, le sommet est considéré comme testable, il est calculé une variable logique T à l'étape 2002. Celle-ci est donnée par :

$$T = (\text{Sommet->compteur\_ancetres=<moyenne})$$
$$\&\&$$
$$(\text{Sommet-compteur\_ancetres>=precedent}).$$

Un test de la valeur de la variable T est effectué à l'étape 2004. Si cette variable est fausse, un nouveau parent du sommet est proposé à l'étape 1912.

En revanche, si la variable T est vraie, alors à l'étape 2006, les valeurs des variables précédentes indic_ coupure_sommet sont modifiées comme indiqué ci-dessous :

$$precedent=Sommet\text{->}compteur\_ancetres$$
$$Indic\_coupure=0$$
$$Solution=Sommet$$

De même, en remplacement de l'étape 1926, et comme représenté sur la figure 21, il est d'abord défini à l'étape 2102 une variable logique T. Celle-ci est définie par :

$$T= (noeud\text{->}compteur\_ancetres=\text{<}moyenne)$$
$$\&\&$$
$$(noeud\text{->}compteur - ancetres\text{>}=precedent)$$

A l'étape 2104, la valeur logique de la variable T est testée. Si celle-ci est fausse, un nouveau parent du sommet est proposé à l'étape 1912.

En revanche, si la variable T est vraie, à l'étape 2106, les valeurs des variables précédentes, indic_coupure et solution sont modifiées comme indiqué ci-dessous :

$$Precedent=noeud\text{->}compteur\_ancetres$$
$$Indic\_coupure=1$$
$$Solution=noeud$$

Après détermination du noeud moyen, le test de celui-ci se fait par sollicitation du testeur à l'étape 232 de la figure 2, correspondant à l'étape 1714 de la figure 17 avec la fonction **tester_noeud( )**. Cette fonction a comme paramètre d'appel l'adresse du noeud à tester.

Avant de solliciter le testeur, cette fonction vérifie si le noeud n'a pas déjà été testé en analysant le contenu du fichier des noeuds testés. Si le résultat est connu, il est immédiatement utilisé dans le programme. Dans le cas contraire, cette fonction interroge le testeur sur ce noeud. La réponse du testeur, indépendamment de son utilisation dans le programme, est archivée dans le fichier des noeuds testés. Ceci évite, si on doit relancer le programme, d'avoir à refaire des tests sur ces noeuds.

La réponse fournie si le noeud a un fonctionnement correct est « 1 ». Si le noeud est trouvé défaillant, la réponse doit être « 0 ».

La sollicitation du testeur est assurée par la fonction **interroger_testeur( )**. Cette fonction écrit dans un fichier texte le nom du noeud à tester et vient périodiquement relire le contenu de ce fichier. Lorsque le testeur a répondu, la fonction retourne la réponse à la fonction **tester_noeud( ).**

Le nom du fichier d'interface (absolu ou relatif) est défini dans le fichier d'en-tête « general.h ». Dans ce fichier sont également définis les autres paramètres intervenant dans le contrôle du testeur (durée entre deux lectures du fichier d'interface et dépassement de temps sur la réponse testeur).

Les opérations d'écriture et de lecture dans le fichier d'interface ne nécessitent aucune synchronisation entre le testeur et le programme.

Des contrôles de cohérence sur le nom du noeud et sur la réponse du testeur sont effectués dans la fonction **interroger_testeur( )** à chaque test.

Le dialogue entre le testeur et le programme suit le protocole suivant :

- Le programme vide ou crée le fichier d'interface et écrit sur la première ligne le nom du noeud à tester sans faire de retour à la ligne.
- Le testeur est censé venir lire périodiquement ce fichier. Dès qu'il détecte la présence d'un nom de noeud nouveau, il effectue le test et répond (en mode « append ») par un retour à la ligne suivi de l'entier 0 ou 1 non suivi d'un retour à la ligne.
- Le programme vient lire périodiquement le fichier d'interface. Dès qu'il détecte la ligne supplémentaire, il sait que le testeur a répondu et le contenu de cette ligne est interprété numériquement par la fonction standard « **fscanf( )** » du langage C.

Les flux du fichier d'interface vers le programme et le testeur sont distincts et peuvent être simultanés.

Un programme « pseudo_testeur » peut être lancé en arrière plan (option & du shell). Il permet d'écrire manuellement dans le fichier d'interface. L'opérateur peut ainsi répondre au clavier à la place du testeur. L'accès simultané au fichier d'interface est ainsi possible par trois flux (le programme, le testeur et le pseudo_testeur).

Pour écrire le programme d'accès du testeur au fichier d'interface, on peut partir du fichier source « pseudo_testeur.c » et des en-têtes associées.

L'algorithme de dichotomie est mis en oeuvre jusqu'à épuisement du sous-arbre minimal. L'analyse après épuisement d'un niveau objet de la phase 126 dans l'organigramme de la figure 1 est demandée par l'algorithme de dichotomie quand il ne reste plus de noeud proposable à tester.

Il s'agit alors de tenter de fractionner l'ensemble des noeuds restant en zones défaillantes.

Suivant le critère d'arrêt choisi et le résultat des tentatives de fractionnement, on restitue soit la valeur 0 (critère non satisfait) soit la valeur 1 (critère satisfait).

Pour un contexte donné de l'algorithme de dichotomie, lorsque tous les noeuds proposables ont été épuisés, les extrémités du sous-arbre analysé ne peuvent être que :

- Des noeuds de sortie de cellules d'entrée. Ces noeuds sont déjà exclus dés le départ. Ils seront dénommés « noeuds d'entrée » ;
- Des noeuds frontières d'USOK (déjà exclus dés le départ) ;
- Des coupures exclues ;
- Des coupures testées mauvaises ;
- Des coupures non testables.

Les noeuds internes restant peuvent être :

- Des noeuds non testables ;
- Des noeuds déclarés « sommet de zone défaillante » ;
- Des noeuds testés mauvais mais non déclarés « sommet de zone défaillante ».

Remarques :

- Il ne peut pas exister d'extrémité non testable qui ne soit ni une entrée, ni une frontière d'USOK, ni une coupure.
- Le sommet de l'arborescence à analyser ne peut être qu'un noeud testable et trouvé mauvais (il ne peut s'agir d'une coupure).
- On considère que les ancêtres d'un sommet de zone défaillante ne sont plus accédés par la suite.

Pour décider si une zone est défaillante, on se réfère à la définition donnée en regard de la figure 5. Il découle de cette définition que la présence de coupures testées mauvaises ou de coupures non testables constitue un obstacle pour déclarer une zone défaillante. Il est donc nécessaire d'analyser l'environnement de ces coupures dans le reste de l'arbre de manière à lever le doute toutes les fois où cela est possible. Cette opération est dénommée "résolution des coupures". Elle consiste à rechercher si les coupures présentes ont leur noeud jumeau dans la zone de recherche en cours.

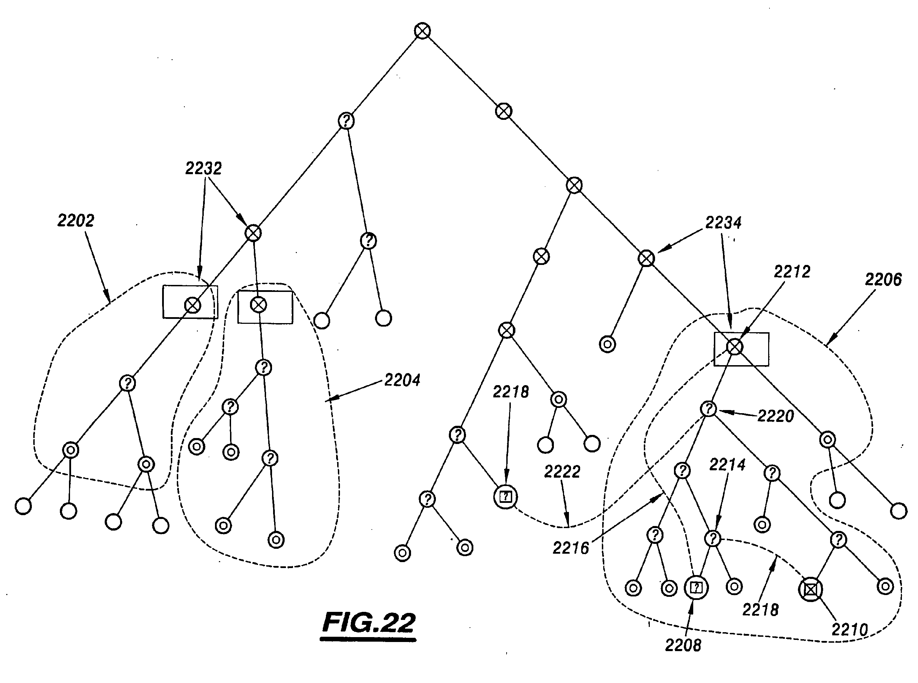

Sur la figure 22 est donné un exemple de résolutions autorisées et interdite, un exemple "d'effet gigogne" et un exemple de trois zones défaillantes séparables. "L'effet gigogne" sera défini dans la suite de la description.

Les noeuds de l'arbre représentés sur la figure 22 sont différenciés en reprenant les conventions graphiques utilisées jusqu'alors. Ainsi, les noeuds mauvais sont désignés par un rond au centre duquel figure croix. Les noeuds non testables sont désignés par un rond à l'intérieur duquel figure un point d'interrogation, les noeuds bons sont désignés par un rond à l'intérieur duquel figure un autre rond, et les coupures sont désignées par un rond à l'intérieur duquel figure un carré.

Les coupures constituant des noeuds non testables ou des noeuds mauvais présentent intérieurement outre un carré, respectivement une croix et un point d'interrogation.

Sur l'arbre de la figure 22, trois zones défaillantes désignées par les références 2202, 2204 et 2206 sont entourées par un cerclage en pointillés. Ces zones défaillantes présentent par définition un sommet constitué d'un noeud mauvais, qui pour des raisons de clarté a été encadré par un rectangle. Ces noeuds mauvais ont pour parent au moins un noeud non testable et éventuellement des noeuds bons.

Les trois zones défaillantes sont séparées puisqu'elles ne comportent pas de noeud commun.

A l'intérieur de la zone défaillante 2206, figurent deux coupures 2208 et 2210. Ces coupures correspondent à des noeuds jumeaux respectivement des noeuds 2212 et 2214. L'association des coupures avec leurs noeuds jumeaux est représentée par un lien pointillé 2216 et 2218.

Dans la mesure où les coupures 2208 et 2210 ont leurs noeuds jumeaux dans une même limite de zone défaillante 2208, la résolution est autorisée.

En revanche, la coupure notée 2218 ayant pour noeud jumeau le noeud 2220 comme indiqué par le lien pointillé 2222 se situe hors de la limite de zone défaillante 2206.

Il est donc inutile de tenter de résoudre cette coupure par accès interne à la zone déclarée défaillante 2206 étant donné que la zone défaillante qui pourrait en résulter inclurait de toute façon la première sans apporter, apparemment, d'information supplémentaire.

D'autre part, une zone ne doit pas être déclarée défaillante si au moins une de ses terminaisons est un sommet de zone déjà déclarée défaillante. On appelle ce phénomène « l'effet gigogne ». Les algorithmes décrits ci-après sont adaptés pour le détecter et en tenir compte.

Des exemples d'effets gigognes identifiés par les références 2230 et 2234 apparaissent sur la figure 22 aux sommets des zones défaillantes 2202 et 2206.

Dans le sous-arbre où est faite l'analyse des noeuds restant, une coupure (mauvaise ou non-testable) peut être connectée à :

Un Nœud ;
- Un nœud exclu ;
- Un nœud non exclu.
  - Sommet ;
  - Nœud interne non testable ;
  - Coupure non testable ;
  - Coupure mauvaise ;
  - Nœud interne testé mauvais.

Rien.

Cependant, il existe, par définition, des impossibilités. Les cas possibles et impossibles sont résumés dans le tableau ci-dessous :

Les impossibilités de résolution sont repérées par la lettre "I" ; elles sont dues à des conflits "bon / mauvais" ou "testable / non-testable". La lettre "P" indique que la résolution de la connexion est possible.

| | | Coupure mauvaise | Coupure Non testable |
|---|---|---|---|
| Connectée à : | Nœud exclu | I | P |
| | Sommet | P | I |
| | Nœud interne non testable | I | P |
| | Coupure non testable | I | P |
| | Coupure mauvaise | P | I |
| | Rien | P | P |
| | Nœud interne mauvais | P | I |

Ceci conduit au tableau suivant résumant les possibilités de résolution des coupures. Les lettres "R" indiquent que la coupure peut être résolue ; la lettre "D" indique que le doute ne peut pas être levé.

Les cases vides correspondent à des résolutions impossibles.

| | | Coupure mauvaise | Coupure Non testable |
|---|---|---|---|
| Connectée à : | Nœud exclu | | R |
| | Sommet | R | |
| | Nœud interne non testable | | R |
| | Coupure non testable | | D |
| | Coupure mauvaise | D | |
| | Rien | D | D |
| | Nœud interne mauvais | R | |

En résumé, le critère de résolution peut s'énoncer :

Une **coupure testée mauvaise** sera résolue si elle a pour jumeau (dans la zone à analyser) le **sommet** ou un **noeud interne testé mauvais**.

Une **coupure non-testable** sera résolue si elle a pour jumeau dans la zone à analyser) un **noeud exclu** (frontière d'USOK ou noeud d'entrée) ou un **noeud interne non-testable.**

L'analyse des noeuds restants consiste donc à dresser la liste des candidats pouvant être déclarés sommet de zone défaillante. Pour chacun de ces candidats, on analyse le sous-arbre dont il est le sommet en appliquant le critère de résolution des coupures. La résolution de toutes les coupures sous ce noeud est la condition nécessaire mais non suffisante pour que la zone puisse être déclarée zone défaillante.

L'algorithme détaillé de l'analyse après épuisement constituant la fonction **analyser_cellules_restantes( )** est donné sur l'organigramme de la figure 23.

La fonction **analyser_ cellules_restantes ()** dispose en entrée du sommet 2302 de l'arbre considéré.

La valeur de ce sommet est testée à l'étape 2304. Si ce sommet est NULL, la variable réponse est fixée à 0 à l'étape 2306 et la valeur de la variable réponse est retournée à l'étape 2308 en tant que résultat de la fonction **analyser_ cellules_restantes ().**

En revanche, si le sommet est différent de NULL à l'étape 2304, la liste des candidats à la résolution est construite à l'étape 2310 par mise en oeuvre de la fonction **construire_liste_candidats** () qui sera décrite en regard de la figure 24.

Lors du test effectué à l'étape 2312, si la liste de candidats est nulle, alors la valeur de la variable réponse est fixée à 0 à l'étape 2314 puis l'étape 2308 est mise en oeuvre.

En revanche, si la liste est non nulle, la fin de la liste est considérée à l'étape 2316 puis à l'étape 2318, un élément de la liste est choisi en remontant celle-ci.

Si lors du test effectué à l'étape 2320, on constate qu'aucun élément ne peut être choisi, la liste est libérée à l'étape 2322 et la variable réponse est fixée à 0 à l'étape 2324 avant que l'étape 2308 ne soit effectuée.

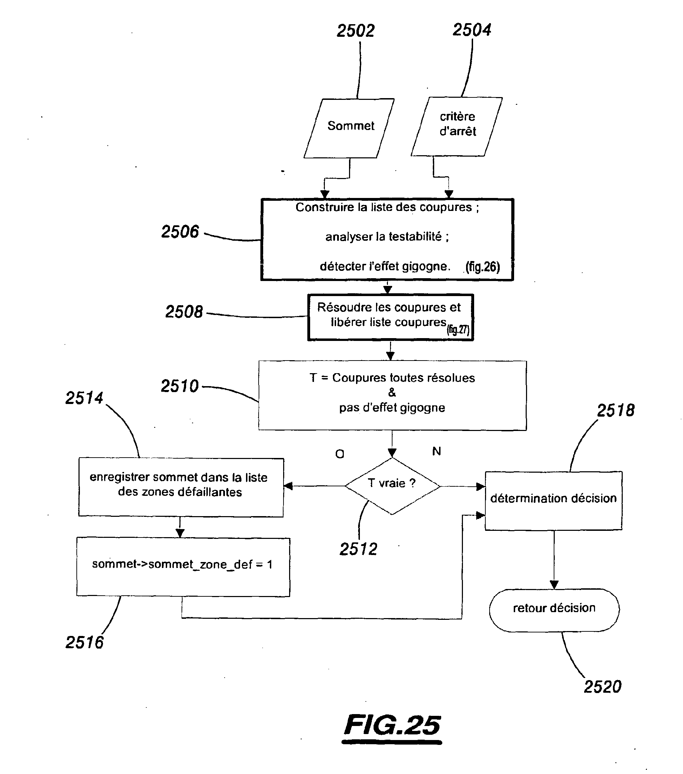

En revanche, si un élément de la liste peut être choisi, il est procédé, à l'étape 2326, à l'analyse des noeuds situés sous ce noeud considéré alors comme au sommet. Cette analyse est effectuée par mise en oeuvre de la fonction **analyser_sous_ce_sommet ()** qui sera décrite ultérieurement en référence à la figure 25.

Après l'analyse sous le noeud choisi, il est vérifié à l'étape 2328 si le critère est ou non satisfait. Si tel n'est pas le cas, les étapes 2318 et suivantes sont à nouveau mises en oeuvre. Au contraire, si le critère est satisfait à l'étape 2330, la variable réponse est fixée à 1 avant que cette réponse soit retournée à l'étape 2308.

Lorsqu'on est dans un contexte donné des récurrences de l'algorithme de dichotomie et qu'on exécute la phase d'analyse du reste de l'arbre, il s'agit de trouver d'éventuelles zones pouvant être déclarées défaillantes. Les différents candidats pouvant tenir le rôle de sommet pour ces zones sont les noeuds testés mauvais et non encore déclarés sommets de zone défaillante.

Pour avoir des zones défaillantes de taille minimale, on doit rechercher les sommets de ces zones parmi les noeuds testés mauvais les plus proches des entrées et remonter ensuite vers le sommet.

Dans un premier temps, on construit à l'étape 240 de la figure 2 correspondant à l'étape 2310 de figure 23 la liste de ces candidats. Pour cela, on parcourt l'arbre suivant la procédure à ordre « post-fixé » en ignorant les noeuds exclus, les coupures et les sommets de zones défaillantes ainsi que leurs ancêtres. On n'enregistre que les sommets testés mauvais que l'on rencontre.

La liste construite doit être relue de la fin vers le début par utilisation du pointeur de parcours inverse.

La liste comporte en fait au moins un élément à savoir : le sommet.

L'algorithme détaillé de construction de la liste constituant la fonction **construire_liste_candidats( )** est donné dans l'organigramme de la figure 24.

La fonction **construire_liste_candidats ()** reçoit en entrée le sommet 2402 de l'arbre considéré. A l'étape 2404 un parent du sommet est proposé. Il est vérifié lors du test de l'étape 2406 si un tel parent existe. Si ce parent existe, il est défini à l'étape 2408 une variable logique notée condition. Cette variable est définie par :

Condition=non exclu & non coupure & non sommet de zone def.

Cette variable condition permet de tester si le parent considéré n'est ni exclu, ni une coupure, ni le sommet d'une zone défaillante.

A l'étape 2410 la valeur booléenne de la variable condition est évaluée. Si celle-ci est fausse, c'est-à-dire que le parent considéré est soit exclu, soit une coupure soit le sommet d'une zone de définition, un nouveau parent est proposé. Si la variable condition est vraie, c'est-à-dire que le noeud considéré n'est pas exclu, n'est pas une coupure et n'est pas le sommet d'une zone défaillante, un nouvel appel récursif à la fonction **construire_liste_candidats ()** avec pour variable le parent considéré est effectué à l'étape 2412. Un nouveau parent est à nouveau proposé à l'étape 2404 à l'issue de l'étape 2412.

Lorsqu'il n'est plus possible de proposer des parents, la réponse au test de l'étape 2406 est négatif. Dans ce cas, il est vérifié à l'étape 2414 si le sommet testé est ou non mauvais. Si tel est le cas, le sommet est enregistré à l'étape 2416 avant l'achèvement de la fonction. Sinon, la fonction **construire_liste_candidats ()** s'achève sans enregistrement du sommet considéré.

L'analyse sous un sommet effectuée à l'étape ultérieure 242 de la figure 2 correspondant à l'étape 2326 de la figure 23 consiste à déterminer si les coupures se trouvant sous un sommet peuvent être résolues.

Dans un premier temps, on établit à l'étape 244 la liste des coupures, on détecte la présence éventuelle de noeuds non testables et la présence éventuelle d'un effet gigogne.

Une fois cette liste établie, on tente à l'étape 246 de résoudre les coupures. En fonction du résultat obtenu, on teste le critère d'arrêt spécifié et on retourne au contexte d'appel.

La détermination de la décision se fait de la façon suivante :

• Si le critère d'arrêt est « une cellule défaillante », décision = 1 si, à la fois, toutes les coupures sont résolues, tous les noeuds internes de la zone sont testables et s'il n'y a pas d'effet gigogne. Dans le cas contraire, décision =0.

- Si le critère d'arrêt est « une zone défaillante », décision = 1 si, à la fois, toutes les coupures sont résolues et s'il n'y a pas d'effet gigogne. Décision = 0 dans le cas contraire.
- Si le critère d'arrêt est « tout », décision = 0 quelle que soit l'analyse.

Le détail de l'algorithme d'analyse sous un noeud sommet constituant la fonction **analyser_sous_ce_sommet ( )** est donné sur la figure 25.

La fonction **analyser_sous_ce_sommet ()** reçoit en entrée le sommet 2502 de l'arbre considéré ainsi qu'un critère d'arrêt 2504.

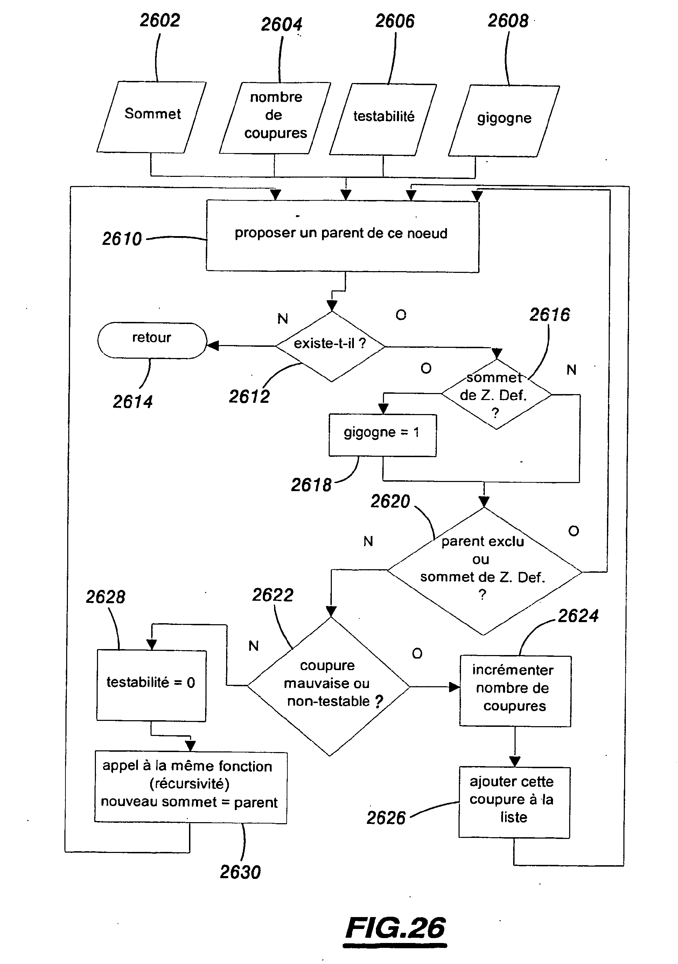

La première étape 2506 consiste à construire la liste des coupures, analyser la testabilité de celle-ci et détecter l'éventualité d'un "effet gigogne". Cette étape est réalisée par la mise en oeuvre de la **fonction lister_coupures_a_ resoudre ()** qui sera décrite en détail en regard de la figure 26.

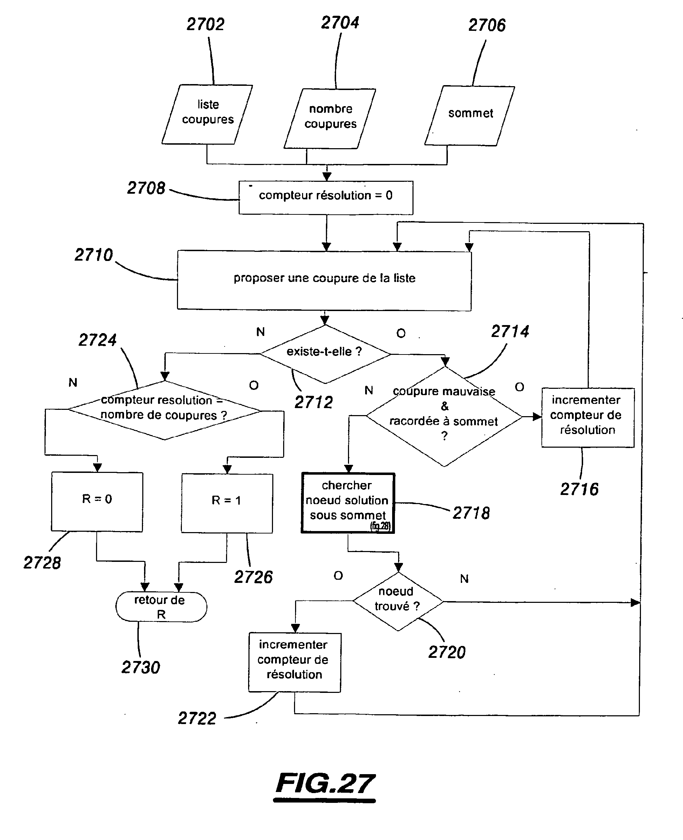

A l'issue de cette étape, les coupures sont résolues à l'étape 2508 et la liste des coupures est libérée. Cette résolution des coupures s'effectue par la fonction **resoudre_coupures ()** qui sera décrite en détail en regard de la figure 27.

A l'étape 2510 est définie une variable logique T. Celle-ci est définie par:

$$T = \text{coupures toutes résolues \& pas d'effet gigogne}$$

Un test est effectué à l'étape 2512 sur la valeur de la variable logique T. Si celle-ci est vraie, c'est-à-dire que toutes les coupures peuvent être résolues et qu'il n'y a pas d'effet gigogne, le sommet considéré en 2502 est enregistré dans la liste des zones défaillantes à l'étape 2514. A l'étape 2516, on effectue l'opération suivante :

$$\text{sommet->sommet\_zone\_def=1.}$$

A l'issue de l'étape 2516, ou si la variable T est fausse à l'issue de l'étape 2510, une décision quant à l'analyse est prise à l'étape 2518 suivant la méthode de détermination exposée précédemment. Ensuite, cette décision est retournée de l'étape 2520 en tant que réponse à la fonction **analyser_sous_ce_sommet ().**

Pour établir la liste des coupures à l'étape 244 de la figure 2 correspondant à l'étape 2506 de la figure 25, on parcourt l'arbre à analyser avec la procédure à ordre préfixé. Dès qu'on trouve un sommet de zone défaillante, un indicateur d'effet gigogne est mis à un. De même, dès qu'un noeud non-testable est rencontré, un indicateur de testabilité est mis à zéro. Dès qu'on rencontre une coupure mauvaise ou non-testable, on la rajoute en tant qu'élément dans la liste et on incrémente le compteur de coupures. La programmation est récursive. Le nouveau sommet est le noeud associé au parent en cours et les paramètres nombre_de_coupures, testabilité et gigogne sont passés par référence pendant les récurrences.

Au premier appel, le nombre_de_coupures doit être initialisé à zéro, testabilité doit être initialisé à un et gigogne doit être initialisé à zéro. Au premier appel, sommet n'est ni exclu, ni coupure, ni sommet de zone défaillante, mais testable et testé mauvais.

L'algorithme détaillé de ia construction de la liste des coupures constituant la fonction **lister_coupures_a_ resoudre ()** est décrit dans l'organigramme de la figure 26.

La fonction **lister_coupures_a_resoudre ()** reçoit en entrée le sommet 2602 de l'arbre considéré, le nombre de coupures 2604, une variable de testabilité 2606 et une variable d'effet gigogne 2608.

Lors de la première étape 2610, un parent du noeud considéré est proposé. Si lors du test effectué à l'étape 2612 il est constaté que ce parent n'existe pas, il est mis un terme à la fonction à l'étape 2614. Si ce parent existe, un test est effectué à l'étape 2616 pour déterminer si le parent de ce noeud est ou non un sommet de zone défaillante. Si tel est le cas, la variable gigogne est mise à 1 à l'étape 2618. Sinon, la variable gigogne est maintenue à sa valeur initiale.

A l'étape ultérieure 2620, il est vérifié s'il s'agit d'un parent exclu ou du sommet d'une zone défaillante. Si la réponse est positive, l'étape 2610 est mise en oeuvre pour proposer un autre parent du noeud considéré. Si la réponse est négative, il est vérifié à l'étape 2622 s'il s'agit d'une coupure mauvaise ou non testable. Si tel est le cas, le nombre de coupures est incrémenté à l'étape 2624 puis cette coupure est ajoutée à la liste des coupures à l'étape 2626. L'étape 2610 est enfin mise en oeuvre pour proposer un nouveau parent du noeud considéré.

En revanche, si à l'étape 2622, il est constaté qu'il ne s'agit ni d'une coupure mauvaise ni d'un noeud non testable, la variable testabilité est mise à 0 à l'étape 2628. Un nouvel appel à la fonction **lister_coupures_a_resoudre ()** est effectué par récursivité à l'étape 2630 en considérant comme sommet le parent déterminé précédemment à l'étape 2610.

A l'issue de cet appel récursif de la fonction, l'étape 2610 est à nouveau mise en oeuvre pour proposer un nouveau parent au noeud considéré.

Le processus décrit ici s'effectue jusqu'à achèvement des parents du noeud considéré.

Pour la résolution des coupures à l'étape 246 de la figure 2, correspondant à l'étape 2508 de la figure 25, on prend chaque coupure de la liste des coupures à résoudre et on cherche si on peut la résoudre dans le sous-arbre dans lequel on fait l'analyse.

Pour décider si la résolution est possible, on applique le critère de résolution énoncé précédemment.

Dans un premier temps, on essaie de résoudre la coupure sur le sommet. Si cette tentative échoue, on recherche une résolution dans le reste de l'arbre avec une procédure récursive. Cette procédure récursive est décrite dans la suite.

La procédure générale de résolution des coupures est détaillée dans l'organigramme de la figure 27 décrivant l'algorithme de la fonction **resoudre_coupures( ).**

La fonction **resoudre_coupures ()** reçoit en entrée la liste des coupures 2702, le nombre des coupures 2704, ainsi que le sommet de l'arbre considéré 2706. Initialement, à l'étape 2708 la variable compteur résolution est mise à 0.

A l'étape 2710, une coupure est proposée dans la liste. Il est vérifié à l'étape 2712 que cette coupure existe. Si tel est le cas, il est déterminé à l'étape 2714 si cette coupure est mauvaise et si celle-ci est raccordée à un sommet. Si tel est le cas, le compteur de résolution est incrémenté à l'étape 2716 et l'étape 2710 est à nouveau mise en oeuvre pour proposer une nouvelle coupure.

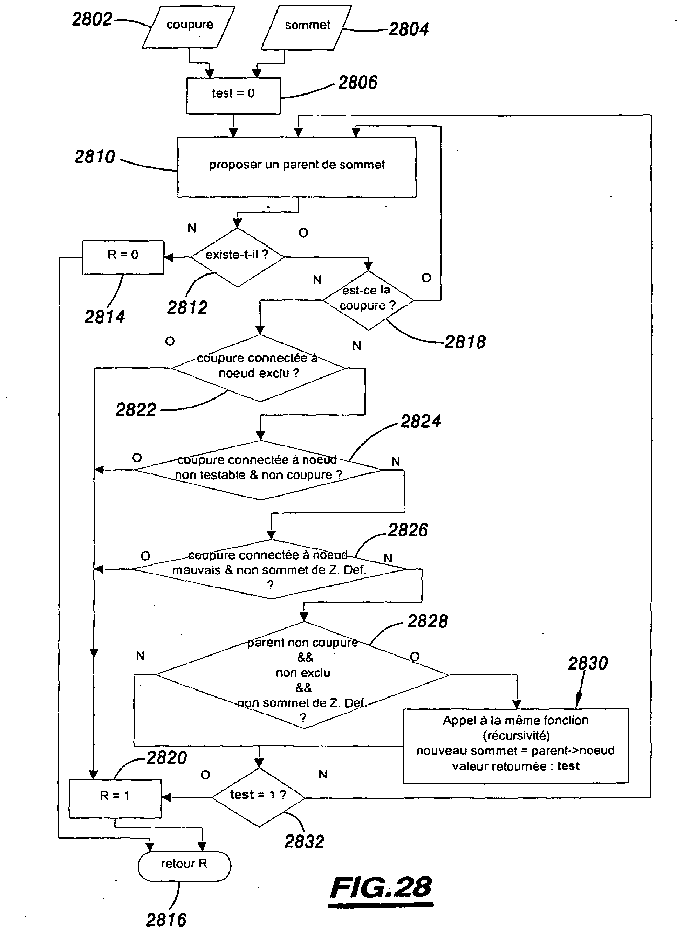

En revanche, si la coupure proposée n'est pas une coupure mauvaise qui est raccordée à un sommet, l'étape 2718 est mise en oeuvre. Celle-ci consiste à rechercher un noeud solution sous le sommet considéré. Cette recherche s'effectue par appel de la fonction **chercher_un_noeud ()** qui sera décrite en regard de la figure 28.

Il est vérifié à l'étape suivante 2720 si un tel noeud a pu être trouvé. Si tel est le cas, le compteur de résolution est incrémenté à l'étape 2722. A l'issue de l'étape 2722, ou dans le cas où aucun noeud n'a été trouvé lors de la recherche 2718, une nouvelle coupure est proposée dans la liste à l'étape 2710.

Si le test opéré à l'étape 2712 révèle qu'il n'existe plus de coupures dans la liste, le compteur de résolution est comparé au nombre de coupures à l'étape 2724. Si ceux-ci sont égaux, la variable R est fixée à 1 à l'étape 2726. Sinon, celle-ci est fixée à la valeur 0 à l'étape 2728. La variable R indique si oui ou non la résolution a été effectuée. Enfin, la variable R est retournée comme solution de la fonction **resoudre_coupure ()** à l'étape 2730.

La recherche d'un noeud solution effectuée à l'étape 2718 et constituant la fonction **chercher_un_noeud( )** est décrite sur la figure 28.

La fonction **chercher_un_noeud ()** reçoit en entrée la coupure considérée 2802 ainsi que le sommet de l'arbre considéré 2804.

Initialement, la valeur de la variable test R est fixée à 0 à l'étape 2806. Un parent du sommet considéré est proposé à l'étape 2810. Il est vérifié à l'étape 2812 si ce parent existe. Si tel n'est pas le cas, la valeur de la variable R est fixée à 0 à l'étape 2814 et la variable R est retournée à l'étape 2816 en tant que résultat de la fonction **chercher_un_noeud ().**

Si le parent existe à l'étape 2812, il est déterminé à l'étape 2818 si ce parent est une coupure. Si tel est le cas, un nouveau parent est proposé à l'étape 2810.

Si tel n'est pas le cas, plusieurs tests sont effectués successivement. Lorsque l'un de ces tests est vérifié, la variable R est fixée à la valeur 1 à l'étape 2820. Le premier test opéré à l'étape 2822 consiste à vérifier si le noeud considéré est une coupure connectée à un noeud exclu. Si la réponse est négative, il est ensuite déterminé à l'étape 2824 si ce noeud est une coupure connectée à un noeud non testable et n'est pas une coupure. Si la réponse est négative, il est déterminé à l'étape 2826 si ce noeud est une coupure connectée à un noeud mauvais et ne constituant pas le sommet d'une zone défaillante. Si la réponse est toujours négative, il est déterminé à l'étape 2828 si, pour le noeud considéré, les parents ne sont pas une coupure, s'il est non exclu et s'il n'est pas le sommet d'une zone défaillante. Si tel est le cas, un nouvel appel récursif de la fonction **chercher_un_noeud ()** est effectué à l'étape 2830. Lors de cet appel récursif, le nouveau sommet considéré est le parent pointant vers le noeud.

Si à l'issue de l'étape 2828 ou 2830 la valeur de la variable test R est égale à 1, lors d'une étape de vérification notée 2832, l'étape 2820 est à nouveau mise en oeuvre. Si la valeur de la variable test n'est pas égale à 1, un nouveau parent du sommet est proposé à l'étape 2810.

## Revendications

1. Procédé de localisation d'un élément défectueux dans un circuit intégré dont l'agencement théorique est connu, du type comportant une succession d'étapes consistant en :

   - la détermination (1708) d'un point de mesure du circuit intégré ; et
   - le test (1714) du point de mesure déterminé par mise en oeuvre de :

- l'application d'une séquence de tests aux entrées du circuit intégré ;
- la mesure de signaux au point de mesure déterminé du circuit intégré, lors de l'application de la séquence de tests ; et
- l'évaluation (1716) du point de mesure par la comparaison des signaux mesurés avec des signaux théoriques devant être obtenus au point de mesure déterminé pour évaluer si le point de mesure est défaillant ou satisfaisant ; et

dans lequel la position de l'élément défectueux du circuit intégré est déterminée à partir des évaluations effectuées aux différents points de mesure déterminés,
**caractérisé en ce qu'**il comporte initialement :

- une étape (102, 108, 110) de modélisation de l'agencement théorique du circuit intégré, sous forme d'au moins un graphe comportant un ensemble de noeuds et d'arcs orientés des entrées du circuit vers les sorties du circuit ;
- considérer comme un sous-graphe de recherche, un sous- graphe dont le noeud formant sommet correspond à un point de mesure défaillant ;

et **en ce que**, pour la recherche de l'élément défectueux, il comporte les étapes de :

- affecter (224) à chaque noeud du sous-graphe de recherche considéré, une variable caractéristique dépendant de la structure du sous-graphe de recherche ;
- considérer (236) comme point de mesure, le point de mesure correspondant à un noeud du sous-graphe considéré, obtenu par application d'un critère prédéterminé portant sur les variables caractéristiques de l'ensemble des noeuds du sous-graphe de recherche considéré ;
- effectuer (1714) un test du point de mesure considéré ;
- considérer (1724) comme nouveau sous-graphe de recherche :

soit, le sous-graphe de recherche préalablement considéré en excluant le noeud correspondant au point de mesure testé et tous ses noeuds parents, si le point de mesure est satisfaisant ;
soit, un sous-graphe dont le noeud correspondant au point de mesure est le sommet, si le point de mesure est défaillant ; et

- rechercher (1726), dans le nouveau sous-graphe de recherche considéré, l'élément défectueux, jusqu'à vérification d'un critère d'arrêt prédéterminé.

2. Procédé de localisation selon la revendication 1, **caractérisé en ce que**, lors de l'étape initiale (012, 108, 110) de modélisation de l'agencement théorique du circuit intégré, le circuit est modélisé sous forme d'un arbre par création éventuelle de noeuds virtuels (810 ; 2208, 2210, 2218) lorsqu'un même noeud est le parent d'au moins deux noeuds, eux-mêmes parents d'un même noeud.

3. Procédé de localisation selon la revendication 2, **caractérisé en ce qu'**il comporte, après vérification du critère d'arrêt prédéterminé, les étapes de:

- évaluer, dans le ou chaque dernier sous-graphe de recherche, si, pour chaque noeud virtuel correspondant à un point de mesure défaillant, le noeud jumeau associé audit noeud virtuel est un noeud du même sous-graphe correspondant également à un point de mesure défaillant ; et
- considérer alors le ou chaque sous-groupe pour lequel la condition est vérifiée comme correspondant à une partie du circuit intégré comportant au moins un élément défectueux.

4. Procédé de localisation selon l'une quelconque des revendications précédentes, **caractérisé en ce que** ladite variable caractéristique propre à chaque noeud est le nombre d'ancêtres de ce noeud dans le sous-graphe de recherche considéré.

5. Procédé de localisation selon la revendication 4 prise avec l'une des revendications 2 et 3, **caractérisé en ce que** ledit critère prédéterminé est adapté pour déterminer le noeud dont le nombre d'ancêtres est sensiblement égal au nombre moyen d'ancêtres par noeud dans le sous-arbre de recherche considéré.

6. Procédé de localisation selon l'une quelconque des revendications précédentes, **caractérisé en ce qu'**il comporte une étape d'affectation à chaque noeud, d'un indicateur de conformité initialement fixé à un état défaillant ; et

**en ce que**, pour la détermination du nouveau sous-graphe de recherche à considérer, il comporte les étapes de :

- fixer (108) l'indicateur de conformité du noeud correspondant au point de mesure testé et de tous ses noeuds parents à un état satisfaisant si le point de mesure testé est satisfaisant ; et

considérer comme nouveau sous-graphe de recherche, le sous-graphe inclus dans le sous-graphe de recherche précédent et comportant les seuls noeuds dont l'indicateur de conformité est fixé à l'état défaillant.

**7.** Procédé de localisation selon l'une quelconque des revendications précédentes, **caractérisé en ce que** le sous-graphe de recherche initialement considéré est formé (216) de l'intersection des sous-graphes ayant chacun pour sommet un noeud correspondant à une sortie défaillante du circuit intégré.

**8.** Dispositif de localisation d'un élément défectueux dans un circuit intégré dont l'agencement théorique est connu, du type comportant des moyens pour effectuer une succession d'étapes consistant en :

- la détermination (1708) d'un point de mesure du circuit intégré ; et
- le test (1714) du point de mesure déterminé par mise en oeuvre de :

- l'application d'une séquence de tests aux entrées du circuit intégré ;
- la mesure de signaux au point de mesure déterminé du circuit intégré, lors de l'application de la séquence de tests ; et
- l'évaluation (1716) du point de mesure par la comparaison des signaux mesurés avec des signaux théoriques devant être obtenus au point de mesure déterminé pour évaluer si le point de mesure est défaillant ou satisfaisant ; et

des moyens pour déterminer la position de l'élément défectueux du circuit intégré à partir des évaluations effectuées aux différents points de mesure déterminés,
**caractérisé en ce qu'**il comporte :

- des moyens de modélisation (102, 108, 110) initiale de l'agencement théorique du circuit intégré, sous forme d'au moins un graphe comportant un ensemble de noeuds et d'arcs orientés des entrées du circuit vers les sorties du circuit ;
- des moyens pour considérer initialement comme un sous-graphe de recherche, un sous-graphe dont le noeud formant sommet correspond à un point de mesure défaillant ;

et **en ce que**, pour la recherche de l'élément défectueux, il comporte des moyens pour :

- affecter (224) à chaque noeud du sous-graphe de recherche considéré, une variable caractéristique dépendant de la structure du sous-graphe de recherche ;
- considérer (236) comme point de mesure, le point de mesure correspondant à un noeud du sous-graphe considéré, obtenu par application d'un critère prédéterminé portant sur les variables caractéristiques de l'ensemble des noeuds du sous-graphe de recherche considéré ;
- effectuer (1714) un test du point de mesure considéré ;
- considérer (1724) comme nouveau sous-graphe de recherche :

soit, le sous-graphe de recherche préalablement considéré en excluant le noeud correspondant au point de mesure testé et tous ses noeuds parents, si le point de mesure est satisfaisant ;
soit, un sous-graphe dont le noeud correspondant au point de mesure est le sommet, si le point de mesure est défaillant ; et

- rechercher (1726), dans le nouveau sous-graphe de recherche considéré, l'élément défectueux, jusqu'à vérification d'un critère d'arrêt prédéterminé.

**Claims**

**1.** Method for locating a defective element in an integrated circuit, the theoretical layout of which is known, having a succession of steps comprising:

- determining (1708) a measurement point of the integrated circuit; and
- testing (1714) the determined measurement point by implementing:

    - application of a sequence of tests at the inputs of the integrated circuit;
    - measurement of signals at the determined measurement point of the integrated circuit during application of the sequence of tests; and
    - evaluation (1716) of the measurement point by comparing the measured signals with theoretical signals that must be obtained at the determined measurement point to evaluate whether the measurement point is faulty or satisfactory; and

in which the position of the defective element of the integrated circuit is determined on the basis of the evaluations performed at different determined measurement points,
**characterised in that** it initially comprises:

    - a step (102, 108, 110) of modelling the theoretical layout of the integrated circuit in the form of at least one diagram comprising a combination of nodes and arcs oriented from the inputs of the circuit towards the outputs of the circuit;
    - considering as a search subdiagram a subdiagram, wherein the node forming the vertex corresponds to a faulty measurement point;

and **in that** for the search for the defective element, it comprises the steps of:

    - assigning (224) a characteristic variable depending on the structure of the search subdiagram to each node of the search subdiagram;
    - considering (236) as measurement point the measurement point corresponding to a node of the considered subdiagram obtained by applying a predetermined criterion relating to the characteristic variables of the combination of nodes of the considered search subdiagram;
    - conducting (1714) a test on the considered measurement point;
    - considering (1724) as new search subdiagram:

        either the search subdiagram initially considered by excluding the node corresponding to the tested measurement point and all its parent nodes, if the measurement point is satisfactory;
        or a subdiagram, in which the node corresponding to the measurement point is the vertex, if the measurement point is faulty; and

    - search (1726) the defective element in the new considered search subdiagram until a predetermined stoppage criterion is verified.

2. Location method according to claim 1, **characterised in that** during the initial step (012, 108, 110) of modelling the theoretical layout of the integrated circuit, the circuit is modelled in the form of a tree by possibly creating virtual nodes (810; 2208, 2210, 2218) when the same node is the parent of at least two nodes, which are themselves parents of the same node.

3. Location method according to claim 2, **characterised in that** after the predetermined stoppage criterion has been verified, it comprises the steps of:

    - evaluating in the or each last search subdiagram whether for each virtual node corresponding to a faulty measurement point the twin node associated with said virtual node is a node of the same subdiagram likewise corresponding to a faulty measurement point; and
    - then considering the or each sub-group for which the condition is verified as corresponding to a part of the integrated circuit having at least one defective element.

4. Location method according to any one of the preceding claims, **characterised in that** said characteristic variable belonging to each node is the number of ancestors of this node in the considered search subdiagram.

5. Location method according to claim 4 combined with one of claims 2 and 3, **characterised in that** said predetermined criterion is adjusted to determine the node, for which the number of ancestors is approximately equal to the average number of ancestors per node in the considered search subtree.

6. Location method according to any one of the preceding claims, **characterised in that** it comprises a step of assigning to each node a conformity indicator initially fixed at a faulty state; and
**in that** to determine the new search subdiagram to be considered, it comprises the steps of:

    - fixing (108) the conformity indicator of the node corresponding to the measurement point tested and of all its parent nodes at a satisfactory state, if the tested measurement-point is satisfactory; and
    - considering as new search subdiagram, the subdiagram included in the preceding search subdiagram and having the only nodes for which the conformity indicator is fixed at a faulty state.

7. Location method according to any one of the preceding claims, **characterised in that** the initially considered search subdiagram is formed (216) from the intersection of the subdiagrams each having as vertex a node corresponding to a faulty output of the integrated circuit.

8. Device for locating a defective element in an integrated circuit, the theoretical layout of which is known, having means to perform a succession of steps comprising:

    - determining (1708) a measurement point of the integrated circuit; and
    - testing (1714) the determined measurement point by implementing:

        - application of a sequence of tests at the inputs of the integrated circuit;
        - measurement of signals at the determined measurement point of the integrated circuit during application of the sequence of tests; and
        - evaluation (1716) of the measurement point by comparing the measured signals with theoretical signals that must be obtained at the determined measurement point to evaluate whether the measurement point is faulty or satisfactory; and

means for determining the position of the defective element of the integrated circuit is determined on the basis of the evaluations performed at different determined measurement points,
**characterised in that** it comprises:

    - means for modelling (102, 108, 110) the theoretical layout of the integrated circuit in the form of at least one diagram comprising a combination of nodes and arcs oriented from the inputs of the circuit towards the outputs of the circuit;
    - means for initially considering as a search subdiagram a subdiagram, wherein the node forming the vertex corresponds to a faulty measurement point,

and **in that** for the search for the defective element, it comprises means to :

    - assign (224) a characteristic variable depending on the structure of the search subdiagram to each node of the search subdiagram;
    - consider (236) as measurement point the measurement point corresponding to a node of the considered subdiagram obtained by applying a predetermined criterion relating to the characteristic variables of the combination of nodes of the considered search subdiagram;
    - conduct (1714) a test on the considered measurement point;
    - consider (1724) as new search subdiagram:

        either the search subdiagram initially considered by excluding the node corresponding to the tested measurement point and all its parent nodes, if the measurement point is satisfactory;
        or a subdiagram, in which the node corresponding to the measurement point is the vertex, if the measurement point is faulty; and

    - search (1726) the defective element in the new considered search subdiagram until a predetermined stoppage criterion is verified.

**Patentansprüche**

1. Verfahren zur Ortung eines defekten Elementes auf einer integrierten Schaltung, deren theoretischer Aufbau bekannt ist, der Art mit einer Abfolge von Schritten, die bestehen aus:

- der Bestimmung (1708) eines Messpunktes der integrierten Schaltung; und
- der Überprüfung (1714) des bestimmten Messpunktes anhand der Durchführung:

- der Anwendung einer Abfolge von Tests an den Eingängen der integrierten Schaltung;
- der Messung von Signalen an dem bestimmten Messpunkt der integrierten Schaltung während der Anwendung der Testabfolge; und
- der Bewertung (1716) des Messpunktes durch Vergleich der gemessenen Signale mit theoretischen Signalen, die an dem bestimmten Messpunkt erhalten werden müssen, um zu bewerten, ob der Messpunkt fehlerhaft oder zufrieden stellend ist; und

wobei die Position des defekten Elementes der integrierten Schaltung anhand der durchgeführten Bewertungen an den verschiedenen bestimmten Messpunkten bestimmt wird,

**dadurch gekennzeichnet, dass** es zu Anfang aufweist:

- einen Schritt (102, 108, 110) der Modellierung des theoretischen Aufbaus der integrierten Schaltung in Form von zumindest einem Graphen mit einer Anordnung von Knotenpunkten und Bögen, die von den Eingängen der Schaltung zu den Ausgängen der Schaltung hin gerichtet sind;
- Ansehen eines Suchuntergraphen, dessen Spitze bildender Knotenpunkt einem defekten Messpunkt entspricht, als einen Suchuntergraph;

und dass das Verfahren zur Suche des defekten Elementes die Schritte aufweist:

- Zuordnung (224) einer charakteristischen Variablen, die von dem Aufbau des Suchuntergraphen abhängt, zu jedem Knotenpunkt des betreffenden Suchuntergraphen;
- Ansehen (236) des Messpunktes, der einem Knotenpunkt des betreffenden Untergraphen entspricht, und der durch Anwendung eines vorbestimmten Kriteriums, das auf die charakteristischen Variablen der Gesamtheit der Knotenpunkte des betreffenden Suchuntergraphen hinausläuft, erhalten wurde, als Messpunkt;
- Durchführung (1714) eines Testes des betreffenden Messpunktes;
- Ansehen (1724) als neuen Suchuntergraphen:

entweder den zuvor berücksichtigten Suchuntergraphen, indem der Knotenpunkt, welcher dem getesteten Messpunkt entspricht, und alle seine verwandten Knotenpunkte ausgeschlossen werden, wenn der Messpunkt zufrieden stellen ist;
oder einen Untergraphen, dessen Knotenpunkt, der dem Messpunkt entspricht, die Spitze bildet, wenn der Messpunkt defekt ist; und

- Suche (1726) des defekten Elementes in dem neuen betreffenden Suchuntergraphen bis zur Bestätigung eines vorbestimmten Stoppkriteriums.

2.  Ortungsverfahren gemäß Anspruch 1, **dadurch gekennzeichnet, dass** während des Eingangsschrittes (102, 108, 110) der Modellierung des theoretischen Aufbaus der integrierten Schaltung die Schaltung in Form eines Baumes durch eventuelle Schaffung virtueller Knotenpunkte (810; 2208, 2210, 2218) modelliert wird, wenn ein gleicher Knotenpunkt verwandt ist mit zumindest zwei Knotenpunkten, welche selbst Verwandte eines selben Knotenpunktes sind.

3.  Ortungsverfahren gemäß Anspruch 2, **dadurch gekennzeichnet, dass** es nach der Bestätigung des vorbestimmten Stoppkriteriums die folgenden Schritte aufweist:

- Bewertung, ob in dem oder jedem letzten Suchuntergraphen für jeden virtuellen Knotenpunkt, der einem defekten Messpunkt entspricht, der dem virtuellen Knotenpunkt zugeordnete Doppelknotenpunkt ein Knotenpunkt desselben Untergraphen ist, der ebenfalls einem defekten Messpunkt entspricht; und
- dann Ansehen des oder jedes Untergraphen, für den die Bedingung bestätigt ist, als entsprechend einem Bereich der integrierten Schaltung, der zumindest ein defektes Element aufweist.

4.  Ortungsverfahren gemäß irgendeinem der vorherigen Ansprüche, **dadurch gekennzeichnet, dass** die charakteristische Variable, die jedem Knotenpunkt zueigen ist, die Anzahl der Vorläufer dieses Knotenpunktes in dem betreffenden Suchuntergraph ist.

5. Ortungsverfahren gemäß Anspruch 4 mit einem der Ansprüche 2 und 3, **dadurch gekennzeichnet, dass** das vorbestimmte Kriterium dafür eingerichtet ist den Knotenpunkt zu bestimmen, dessen Vorläuferanzahl praktisch gleich der mittleren Vorläuferanzahl pro Knotenpunkt in dem betreffenden Suchunterbaum ist.

6. Ortungsverfahren gemäß irgendeinem der vorherigen Ansprüche, **dadurch gekennzeichnet, dass** es einen Schritt zur Zuordnung eines zu Beginn auf einen defekten Zustand festgelegten Konformitätsindikators zu jedem Knotenpunkt aufweist; und
   dass es zur Bestimmung des neuen zu berücksichtigenden Suchuntergraphen die Schritte aufweist:

   - Festlegen (108) des Konformitätsindikators des Knotenpunktes, der dem überprüften Messpunkt entspricht, und aller seiner verwandten Knotenpunkte auf einen zufrieden stellenden Zustand, falls der überprüfte Messpunkt zufrieden stellend ist; und
   - Ansehen des Untergraphen, der in dem vorherigen Suchuntergraphen eingeschlossen ist und einzig die Knotenpunkte aufweist, deren Konformitätsindikator auf den defekten Zustand festgelegt ist, als neuen Suchuntergraphen.

7. Ortungsverfahren gemäß irgendeinem der vorherigen Ansprüche, **dadurch gekennzeichnet, dass** der zu Anfang berücksichtigte Suchuntergraph von der Kreuzung der Untergraphen gebildet ist (216), welche jeweils als Spitze einen Knotenpunkt besitzen, der einem defekten Ausgang der integrierten Schaltung entspricht.

8. Vorrichtung zur Ortung eines defekten Elementes auf einer integrierten Schaltung, deren theoretischer Aufbau bekannt ist, der Art mit Vorrichtungen zur Durchführung einer Abfolge von Schritten, die bestehen aus:

   - der Bestimmung (1708) eines Messpunktes der integrierten Schaltung; und
   - der Überprüfung (1714) des bestimmten Messpunktes anhand der Durchführung:
   - der Anwendung einer Abfolge von Tests an den Eingängen der integrierten Schaltung;
   - der Messung von Signalen an dem bestimmten Messpunkt der integrierten Schaltung während der Anwendung der Testabfolge; und
   - der Bewertung (1716) des Messpunktes durch Vergleich der gemessenen Signale mit theoretischen Signalen, die an dem bestimmten Messpunkt erhalten werden müssen, um zu bewerten, ob der Messpunkt fehlerhaft oder zufrieden stellend ist; und Vorrichtungen zur Bestimmung der Position des defekten Elementes der integrierten Schaltung anhand der Bewertungen, die an verschiedenen bestimmten Messpunkten durchgeführt werden,

   **dadurch gekennzeichnet, dass** sie aufweist:

   - Vorrichtungen zur anfänglichen Modellierung (102, 108, 110) des theoretischen Aufbaus der integrierten Schaltung in Form von zumindest einem Graphen mit einer Anordnung von Knotenpunkten und Bögen, die von den Eingängen der Schaltung zu den Ausgängen der Schaltung hin gerichtet sind;
   - Vorrichtungen, um anfänglich einen Suchuntergraphen, dessen Spitze bildender Knotenpunkt einem defekten Messpunkt entspricht, als einen Suchuntergraph anzusehen;

   und dass die Vorrichtung zur Suche des defekten Elementes Vorrichtungen aufweist, um:

   - jedem Knotenpunkt des betreffenden Suchuntergraphen eine charakteristische Variable zuzuordnen (214), die von dem Aufbau des Suchuntergraphen abhängt;
   - den Messpunkte, der einem Knotenpunkt des betreffenden Untergraphen entspricht, und der durch Anwendung eines vorbestimmten Kriteriums, das auf die charakteristischen Variablen der Gesamtheit der Knotenpunkte des betreffenden Suchuntergraphen hinausläuft, erhalten wurde, als Messpunkt anzusehen (236);
   - einen Test des betreffenden Messpunktes durchzuführen (1714);
   - als neuen Suchuntergraphen anzusehen (1724):

   entweder den zuvor berücksichtigten Suchuntergraphen, indem der Knotenpunkt, welcher dem getesteten Messpunkt entspricht, und alle seine verwandten Knotenpunkte ausgeschlossen werden, wenn der Messpunkt zufrieden stellen ist;

oder einen Untergraphen, dessen Knotenpunkt, der dem Messpunkt entspricht, die Spitze bildet, wenn der Messpunkt defekt ist; und

- in dem neuen betreffenden Suchuntergraphen das defekte Element zu suchen (1726) bis zur Bestätigung eines vorbestimmten Stoppkriteriums.

*102*

*106*

*100*

interprétation

fichier EDIF

fichier session

Traitements préliminaires
marquages

*108*

*114*

*110*

liste SNOK

*112*

Construction arbre de référence
construction des masques
construction de l'intersection
exclusion de l'USOK
exclusion des entrées
génération du sommet virtuel
numérotation

liste SOK

*104*

mémoire
(interne) de
session

fichiers
résultats

*116*

*118*

*130*

chargement des listes

liste noeuds
interdits

*120*

*124*

dichotomie

niveaux métal

*126*

analyse après
épuisement

*123*

Journal

sorties

noeuds testés

*132*

*128*

*122*

**FIG.1**

102 { mise en forme fichier ⟩—202

108 {
définition des
cônes d'influence de
chaque sortie
et
marquage des noeuds
(fig.11)
—204

—208

110 {
détermination de
l'abre de référence —212

construction de la
liste des masques —214

intersection des
SNOK —216

recherche des intersections
minimales connexes —218

exclusion des SOK
et des entrées —220

définition d'un
sommet virtuel —222

numérotation —224

*FIG.2*

calcul de la moyenne
(fig.19)

localisation du noeud
moyen (fig.20 et 21)

fig.18

existence
d'un noeud
testable?

N

O

sollicitation du testeur

124
(fig.17)

230

234

236

233

232

construction liste
des candidats
(fig.24)

liste des coupures
(fig.26)

fig.25

rèsoudre coupure
(fig.27)

240

244

242

246

126
(fig.23)

sortie

128

# FIG.2 suite et fin

**FIG.3**

**FIG.4**

**FIG.5**

**FIG.6**

cellule

**FIG.7**

cellule 1

cellule 2

808

804

806

802

**FIG.8A**

**FIG.8B**

**FIG.9**

départ

n = 0 — *1000*

O            N

fin ← n >= nombreDeSorties ?

*1002*

Détermination du noeud de
départ associé à la sortie n
du composant — *1004*

*1006* — Marquer ce noeud pour la sortie n

Appliquer la fonction
**noeud_cherche_sorties( )**
pour ce noeud de départ,
le nom de la sortie associée
et le numéro de sortie n
Le paramètre de mode est égal à 0.

*1008*

*1010* — n = n+1

# FIG.10

*1102*

*1104*

*1106*

*1108*

noeud

nom
cellule
précédente

numéro
de sortie
composant

mode

choisir une broche connectée à ce noeud

*1110*

retour  ← N — existe-t-elle ? — O

*1112*

N — est-elle connectée
à la cellule précédente ? — O

*1114*

*1116*

O — est-ce une broche
de sortie ? — N

*1118*

appel à la fonction **sortie_cherche_noeuds( )**
*paramètres : pointeur sur la cellule à laquelle appartient cette sortie;*
*numéro de la sortie composant;*
*adresse du noeud appelant;*
*mode*

# FIG.11

*1202*

*1204*

*1206*

*1208*

pointeur
cellule

numéro
sortie
composant

noeud
départ

mode

*1210*

N la cellule est -elle
une cellule d'entrée / sortie ? O

retour

choisir une broche d'entrée de cette nouvelle cellule *1212*

O existe-t-elle ? N

*1214*

O mode = 0
? N

*1218*

O le noeud qui y est
connecté
est-il déjà marqué
ou référencé ? N

*1216*

*1220*

O mode = 0
? N

Ajouter un parent à
noeud_départ
en tant que **coupure**.

Marquer ce noeud pour la sortie n
et
incrémenter le compteur de noeuds
de la sortie n

**Référencer** ce
noeud
et **Ajouter** ce noeud
à la liste des parents
de noeud_départ

*1240*

*1222*

*1242*

Appel à la fonction **noeud_cherche_sorties( )**
paramètres : nouveau noeud;
nom de la cellule qui y est connectée;
numéro sortie composant;
mode.

*1224*

# FIG.12

Snok2

Snok1 *1306* *1308* Sok1 *1302*

Sok2

*1304*

SM

### FIG.13

SNOK4

SNOK2 *1406* *1410*

SNOK1 SNOK3 *1408*

*1402*

*1412* *1414*

### FIG.14

Arbre de référence

Intersection

**FIG.15**

FIG.16

*1702* *1704* *1706*

critère
d'arrêt

sommet
virtuel

sommet
de la
recherche

*1708*

début

Proposer un noeud moyen satisfaisant les contraintes spécifiées
(fig.18)

N          O

ce noeud existe ?

Analyser le reste de l'arbre
(fig.24 à 28)

tester ce noeud          *1714*

*1710*

*1712*

*1720*          N          O          *1718*

noeud bon ?

Le marquer mauvais

*1716*

L'exclure et renuméroter
depuis "sommet virtuel"

N          O

coupure ?

*1722*

Nouveau sommet de recherche = noeud moyen
appel à la même fonction (récursivité)          *1724*

O          N

Critère d'arrêt
satisfait ?

*1728*          *1726*

Retour décision critère

**FIG.17**

*1802*

sommet
de la
recherche

*1804*

*1806*

*1810*

Solution = 0
indic_coupure = 0

O ← Sommet = NULL ? → N

Calcul Nombre_total_de_noeuds
Cumul_des_nombres_d_ancêtres

Moyenne =
Cumul_des_nombres_d_ancêtres /
Nombre_total_de_noeuds (fig.19)

O ← Nombre_total_de_noeuds
> 1 → N

*1816*

*1812*

Moyenne =
Cumul_des_nombres_d_ancêtres

*1814*

*1818* — Localiser "noeud moyen" (Solution)
Donner l'indicateur de coupure
(fig.19,20 et 21)

Solution = 0
indic_coupure = 0

O ← Solution = NULL ?
ou
Solution = sommet ? → N

*1822*

*1820*

Retour Solution
et
indic_coupure

*1808*

# FIG.18

**FIG.19**

2002

T = (Sommet->compteur_ancetres =< moyenne)
&&
(Sommet->compteur_ancêtres >= precedent)

O       N

T est vraie
?

2004

precedent = Sommet->compteur_ancetres
indic_coupure = 0
Solution = Sommet

2006

*FIG.20*

2102

T = (noeud->compteur_ancetres =< moyenne)
&&
(noeud->compteur_ancêtres >= precedent)

O       N

T est vraie
?

2104

precedent = noeud->compteur_ancetres
indic_coupure = 1
Solution = noeud

2106

*FIG.21*

**FIG.22**

**2302**
Sommet

**2310**
Construire liste des candidats (fig.24)

Sommet = 0 ?    O    reponse = 0    **2306**

**2304**

N

**2312**
liste nulle ?    O    reponse = 0    **2314**

N

se placer en fin de liste    **2316**

Retourner reponse    **2308**

Choisir un élément de la liste en remontant depuis la fin de la liste.    **2318**

**2326**
analyser sous ce noeud (fig.25)

reponse = 0    **2324**    liberer la liste    **2322**    existe-t-il ?    **2320**    N    O

reponse = 1    **2330**    critère satisfait ?    **2328**    O    N

**FIG.23**

51

*2402*

Sommet

*2404*

proposer un parent de sommet

*2408*

existe-t-il ?  N  O

*2406*

condition =
non exclu
&
non coupure
&
non sommet de zone def.

*2414*

sommet
testé
mauvais ?  N  O

condition
vraie ?  O  N

*2410*

enregistrer
sommet  *2416*

appel de la même fonction
(récursivité)
sommet = parent

retour  *2412*

## FIG.24

**2502**　**2504**

Sommet　critère d'arrêt

**2506**　Construire la liste des coupures ;
analyser la testabilité ;
détecter l'effet gigogne.　(fig.26)

**2508**　Résoudre les coupures et
libérer liste coupures (fig.27)

**2510**　T = Coupures toutes résolues
&
pas d'effet gigogne

**2514**

**2518**

enregistrer sommet dans la liste
des zones défaillantes

O　N

T vraie ?

détermination décision

**2512**

sommet->sommet_zone_def = 1

retour décision

**2516**

**2520**

# FIG.25

2602    2604    2606    2608

Sommet | nombre de coupures | testabilité | gigogne

2610 — proposer un parent de ce noeud

N / O

retour

existe-t-il ?

2614    2612

2616

sommet de Z. Def. ?    N

O

gigogne = 1

2618

2620

parent exclu ou sommet de Z. Def. ?    O

N

2628    2622

2624

testabilité = 0

coupure mauvaise ou non-testable ?    O    incrémenter nombre de coupures

N

appel à la même fonction (récursivité) nouveau sommet = parent

ajouter cette coupure à la liste

2626

2630

**FIG.26**

54

2702    2704    2706

liste coupures

nombre coupures

sommet

2708 — compteur résolution = 0

2710 — proposer une coupure de la liste

N    existe-t-elle ?    O    2714

2724    2712    N    coupure mauvaise & racordée à sommet ?    O    incrementer compteur de résolution

N    compteur resolution = nombre de coupures ?    O    2716

R = 0    R = 1    chercher noeud solution sous sommet (fig.28)    2718

2728    2726    O    noeud trouvé ?    N

retour de R    incrementer compteur de résolution    2720

2730    2722

**FIG.27**

2802 — coupure

sommet — 2804

test = 0 — 2806

2810 — proposer un parent de sommet

2812 existe-t-il ?

N → R = 0 — 2814

O → est-ce la coupure ? — 2818

N → coupure connectée à noeud exclu ? — 2822

O

N → coupure connectée à noeud non testable & non coupure ? — 2824

O

N → coupure connectée à noeud mauvais & non sommet de Z. Def. ? — 2826

O

N → parent non coupure && non exclu && non sommet de Z. Def. ? — 2828

O → Appel à la même fonction (récursivité) nouveau sommet = parent->noeud valeur retournée : test — 2830

2820 — R = 1

test = 1 ? — 2832

retour R — 2816

**FIG.28**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0444487 A

**Littérature non-brevet citée dans la description**

- **R. DESPLATS et al.** New methodology for lacalizing faults in programmable and commercial circuits. *Microelectronics and Reliability,* Octobre 1997, vol. 37 (10/11), 1619-1622